# EUROPEAN PATENT SPECIFICATION

(11) **EP 1 948 850 B1**
(45) Date of publication and mention of the grant of the patent: **17.04.2019**
(21) Application number: 06813033.5
(22) Date of filing: 20.11.2006
(51) Int. Cl.: C25D 5/02, C25D 21/08, C25D 21/11, C25F 3/14, H01L 21/288, H01L 21/3213, H01L 21/768

(54) **METHOD OF FORMING A MULTILAYER STRUCTURE**
VERFAHREN ZUR BILDUNG EINER MEHRSCHICHTSTRUKTUR
PROCEDE DE FORMATION DE STRUCTURE MULTICOUCHE

(30) Priority: 18.11.2005 SE 0502538; 18.11.2005 SE 0502539
(43) Date of publication of application: 30.07.2008
(73) Proprietor: Luxembourg Institute of Science and Technology (LIST), 4362 Esch-sur-Alzette (LU)
(72) Inventor: FREDENBERG, Mikael, S-112 34 Stockholm (SE); MÖLLER, Patrik, S-112 29 Stochholm (SE); WIWEN-NILSSON, Peter, S-115 27 Stockholm (SE)
(74) Representative: Lecomte & Partners
(86) International application number: PCT/SE2006/001319
(87) International publication number: WO 2007/058603

(56) References cited:
- WO-A1-02/103085
- WO-A1-02/103085
- WO-A1-03/095715
- WO-A2-2004/099469
- DE-A1- 19 935 558
- US-A- 6 027 630
- US-A1- 2005 032 362
- US-A1- 2005 032 362

## Description

The present invention relates to a plating method for simplifying production of applications involving micro and nano structures in multiple layers. The method is particularly useful for fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, etc. Different types of structures in conductive polymers, structures in semiconductors, structures in metals, and others are possible to produce using this method. Even 3D-structures in silicon, by using formation of porous silicon, are possible to produce.

### BACKGROUND ART

WO 02/103085 relates to an electrochemical pattern replication method, ECPR, and a construction of a conductive electrode for production of applications involving micro and nano structures. An etching or plating pattern, which is defined by a conductive electrode, master electrode, is replicated on an electrically conductive material, a substrate. The master electrode is put in close contact with the substrate and the etching/plating pattern is directly transferred onto the substrate by using a contact etching/plating process. The contact etching/plating process is preformed in local etching/plating cells that are formed in closed or open cavities between the master electrode and the substrate.

Patent application US 2005/0202180 discloses electrochemical' fabrication methods for forming single and multilayer mesoscale and microscale structures. In the method, diamond machining (e.g. fly cutting or turning) is used to planarize layers. Moreover, sacrificial and structural materials are described, which are useful in electrochemical fabrication and which can be diamond machined with minimal tool wear (e.g. Ni-P and Cu, Au and Cu, Cu and Sn, Au and Cu, Au and Sn and Au and Sn-Pb, where the first material or materials are the structural materials and the second is the sacrificial material). Methods for reducing tool wear are also described when using diamond machining to planarize structures being electrochemically fabricated using difficult-to-machine materials, e.g. by depositing difficult to machine materials selectively and potentially with little excess plating thickness, and/or pre-machining depositions to within a small increment of desired surface level (e.g. using lapping or a rough cutting operation) and then using diamond fly cutting to complete the process and/or forming structures or portions of structures from thin walled regions of hard-to-machine material as opposed to wide solid regions of structural material.

Patent application US 6,027,630 a method of forming a multilayer structure by electroplating on a substrate, comprising steps a), b), c), d), g) and h) of claim 1 and steps a), b), c), d) and h) of claim 5.

Patent application US 2005/0032362 A1 discloses a method for forming three-dimensional structures. After deposing a first layer of conductive material on a surface, the surface of said first layer is treated to be less susceptible to receive a second layer of a conductive material /or to quickens the removal of said second layer on the treated surface.

A master electrode, which may be used in the present invention, is described in Swedish patent application No. 0502539-2 entitled: "Electrode and method of forming the electrode". The content of this patent specification is incorporated herein by reference.

A problem of prior art multilayer methods is the fact that during the planarization step, at least two materials are required to be removed at the same time. The problem is larger if the two materials have different properties, such as if one of the material is hard, such as a metal, and the other material is soft, such as a plastics material, glass material or porous material, for example a dielectricum. If the planarization takes place by a mechanical polishing action or chemical-mechanical polishing action, several problems may arise. Such polishing action is performed by a plate which moves relative to the material to be planarized, such as by rotation, translation or rolling. During the initial stage of the planarization, material is removed only at the top or ridges of the material. During this stage, there is a risk that the underlying structure may be damaged, especially if the abrasion speed is high. This risk may be decreased by partly dissolving the material by chemical means.

During the intermediate stage of the planarization, no specific problems arise, but the abrasion is relatively straight forward, as long as only the soft or hard material is encountered.

During a final stage of the planarization, both soft material and hard material may be removed. This may result in that the soft material is removed at a higher rate than the hard material, known as erosion or dishing, resulting in recessions in the soft material between the hard material. The final result may be unsuitable for the following processing.

Another problem with mechanical planarization, it that there is a risk that the plate is not completely parallel with the structure layer formed. A small angular deviation may result in that part of the structure is not uncovered as desired.

A further problem of prior art multilayer methods is the fact that the thickness of the structure layer may be difficult to control.

A still further problem of prior art multilayer methods is the fact that the prior art method requires many process steps, which makes the process cumbersome and expensive. A yet further problem of prior art multilayer methods is the fact that it cannot fill holes in the structure in an even manner.

Yet another problem is that it may be difficult to achieve a plane final result if the structures are relatively uneven from the start.

Further problems may be gathered from that stated below.

### SUMMARY OF THE INVENTION

An object of the present invention is to provide a method for forming multilayer structures, in which the risk of erosion or dishing has been reduced or even eliminated. A further object is to provide a method of forming multilayer structures, in which the number of steps may be reduced.

In an aspect of the invention, there is provided a method of forming a multilayer structure by electroplating on a substrate, comprising the steps of: a) arranging an electrically conducting seed layer on at least a part of the substrate or a substrate layer; b) applying a master electrode on said seed layer, said master electrode having an electrically conducting electrode layer, an insulating pattern layer and predeposited anode material arranged onto said conducting electrode layer in the cavities of said insulating pattern layer, for forming at least one electrochemical cell comprising an electrolyte in the area enclosed by said anode material, said insulating pattern layer and said seed layer; wherein said anode material is being in electrical contact with said conducting electrode layer; c) applying a voltage between said conducting electrode layer and said seed layer so that said seed layer forms a cathode for transferring at least some of said anode material in said at least one cell to said seed layer for forming plated structures corresponding to the cavities of the insulating pattern layer on the master electrode; d) separating said master electrode from said substrate; e) removing said seed layer in non-plated areas,- f) arranging a dielectric material by spin-coating in the areas in between the plated structures for forming a material layer that at least partly covers said plated structures; g) planarization of the material layer, until at least part of the structures is uncovered; h) repeating at least some of said steps for providing a multilayer structure.

In an embodiment, the method may further comprise: planarization of the material layer; wherein said step of planarization further comprises removing further material by a removal method having substantially uniform removal rate over the entire surface until at least a part of the structures is uncovered. The method may further comprise: between the steps d) and e) applying a further master electrode for forming electrochemical cells with the structures previously formed; and applying a voltage for forming a further layer of plated structures on top of the previously formed layer of structures. The step of planarization may be performed by at least one polishing and/or etching step. The step of polishing may comprise removing a portion of said material layer by an abrasive action. The at least one polishing step may be performed by a method selected from the group comprising: mechanical- polishing, chemical-polishing, chemical-mechanical -polishing (CMP), contact planarization (CP), planarization with a doctor blade, and combinations thereof. The polishing step may be performed by CMP or CP. The at least one etching step may be performed by a method selected from the group comprising: dry- etching methods, ion-sputtering, reactive-ion-etching (RIE), plasma-assisted-etching, laser-ablation, ion-milling, and combinations thereof.

In a further aspect, there is provided a method of forming a multilayer structure by electroplating on a substrate, comprising: a) arranging an electrically conducting seed layer on at least a part of the substrate or a substrate layer; b) applying a master electrode on said seed layer, said master electrode having an electrically conducting electrode layer an insulating pattern layer and predeposited anode material arranged onto said conducting electrode layer in the cavities of said insulating pattern layer, for forming at least one electrochemical cell comprising an electrolyte in the area enclosed by said anode material, said insulating pattern layer and said seed layer; wherein said anode material is being in electrical contact with said conducting electrode layer; c) applying a voltage between said conducting electrode layer and said seed layer so that said seed layer forms a cathode for transferring at least some of said anode material in said at least one cell to said seed layer for forming plated structures corresponding to the cavities of the insulating pattern layer on the master electrode; d) separating said master electrode from said substrate; e) removing said seed layer in non-plated areas; f) arranging a dielectric material by spin-coating in the areas in between the plated structures for forming a material layer that covers said plated structures; i) providing recesses in said material layer for uncovering at least a part of the plated structure there below; h) repeating at least some of said steps for providing a multilayer structure.

In an embodiment, the step of providing recesses in said material layer may be performed by a lithographic method selected from the group comprising: photolithography, laser lithography, E-beam lithography, nanoimprinting and combinations thereof. The lithographic method may further comprise patterning an etch-mask and etching said material layer with dry-etching methods, such as ion-sputtering, reactive-ion-etching, plasma-assisted-etching, laser-ablation, ion-milling or combinations thereof. The etch-mask may comprise a material selected from the group comprising: a resist, such as a photoresist; a hard-mask, such as SiN, SiO2, SiC, tetraethyl orthosilicate (TEOS), SiON, SiOC, SiCN:H, (non-porous) fluorine doped silicon glass (FSG), (non-porous) organic doped silicon glass (OSG), a low-k dielectric barrier/etch stop film such as BLOk(TM), Pt, Ti, TiW, TiN, Al, Cr, Au, Ni, Cu, Ag, metals and by combinations thereof. The etch-mask may be dry-etched using a resist, such as a photoresist, as a mask; whereas said resist may be patterned with said lithographic method. The step of arranging material in the areas between the plated structures may be performed for forming a material layer having at least the thickness of two structure layers.

In another embodiment, the material layer may be planarized before providing recesses.

In a further embodiment, the method may further comprise applying a barrier/capping layer before step a). The method may further comprise applying a barrier/capping coating before step f). The seed layer may be made of a material selected from the group comprising: Ru, Os, Hf, Re, Cr, Au, Ag, Cu, Sn, Ti, Ni, Al, alloys of these material, Si, conducting polymers such as polyaniline; solder materials, such as SnPb, SnAg, SnAgCu, SnCu; alloys, such as monel and permalloy; and combinations thereof. The seed layer may be applied by a method selected from the group comprising: chemical-vapor-deposition (CVD), metallorganic-chemical-vapor-deposition (MOCVD), physical- vapor-deposition (PVD), atomic layer deposition (ALD), sputtering, electroless plating, electroplating, electro- grafting, and immersion deposition.

The material layer may be a layer of a dielectric material and is applied by a method selected from the group comprising: spin-coating, spray-coating, powder-coating, dip- coating, roller-coating, sputtering, PVD, CVD, Plasma- Enhanced-Chemical-Vapor-Deposition (PECVD), electrodeposition, and combinations thereof. The dielectric material may comprise at least one layer of a material selected from the group comprising: low-k dielectric materials, ultra low-k dielectrics, dielectric materials with k-value less than 4, dielectric materials with k-value less than 2.5; organic compounds, insulating in-organic compounds, oxides, nitrides, polymer materials, polyimide, siloxane modified polyimide, BCB, SU-8, polytetrafluoroethylene (PTFE), silicones, elastomeric polymers, E-beam resists, ZEP (Sumitomo), photoresists, thinfilm resists, thickfilm resists, polycyclic olefins, polynorborene, polyethene, polycarbonate, PMMA, BARC materials, Lift-Off-Layer (LOL) materials, PDMS, polyurethane, epoxy polymers, fluoro elastomers, acrylate polymers, (natural) rubber, silicones, lacquers, nitrile rubber, EPDM, neoprene, PFTE, parylene, fluoromethylene cyanate ester, inorganic-organic hybrid polymers, (fluorinated and/or hydrogenated) amorphous carbon, organic doped silicon glass (OSG), fluorine doped silicon glass (FSG), PFTE/silicon compound, tetraethyl orthosilicate (TEOS), SiN, SiO2, SiON, SiOC, SiCN:H, SiOCH materials, SiCH materials, silicates, silica based materials, silsesquioxane (SSQ) based material, (nanoporous) methyl-silsesquioxane (MSQ), hydrogen- silsesquioxane (HSQ), TiO2, Al2O3, TiN and combinations thereof.

In an embodiment, the seed layer is made of a material selected from the group comprising: Ru, Os, Hf, Re, Cr, Au, Ag, Cu, Sn, Ti, Ni, Al, alloys of these material, Si, conducting polymers such as polyaniline,- solder materials, such as SnPb, SnAg, SnAgCu, SnCu; alloys, such as monel and permalloy; and combinations thereof. The seed layer may be applied by a method selected from the group comprising: chemical-vapor-deposition (CVD), metallorganic-chemical-vapor- deposition (MOCVD), physical-vapor-deposition (PVD), atomic layer deposition (ALD), sputtering, electroless plating, electroplating, electro-grafting, and immersion deposition.

In an embodiment, the planarization step may comprise performing a polishing step until said material surface is substantially planar and a subsequent etching step of said material surface until at least part of said structures is uncovered. A planarizing material may be applied onto said material layer prior to performing said planarization step of said material layer. The planarizing material may be applied with a method selected from the group comprising: spin-coating, spray-coating, powder-coating, dip-coating, roller- coating, sputtering, PVD, CVD, PECVD, electrodeposition, and combinations thereof. In another embodiment, an end-point detection method may be used so as to determine when said planarization step is completed. The end-point detection method may be selected from the group comprising: detecting when said structure material is being abraded or etched; determining the height of said material layer; and analyzing the color of said material layer. The detection may be based on interferometry of spectral analysis of said abraded material or said height is being determined by laser measurements or said color of said material is analyzed by using a sensor and a camera. The step of contact planarization may comprise: applying a plate above said material layer and applying a pressure on said plate for equalizing the material in said material layer, while in a flowable condition. The flowable condition may be obtained by heating said material layer, whereupon the material is cooled after planarization. The step of applying the plate is performed before curing said material, whereupon the material is cured after planarization, such as by applying infrared or ultraviolet radiation.

In a further embodiment, the seed layer is applied by a method selected from the group comprising: chemical-vapor- deposition (CVD), metallorganic-chemical-vapor-deposition (MOCVD), physical-vapor-deposition (PVD), atomic layer deposition (ALD), sputtering, electroless plating, electroplating, electro-grafting, immersion deposition, and combinations thereof. The arranging of a seed layer; and/or said arranging of a material; and/or said plating; and/or said etching; are performed by a method resulting in a controlled thickness.

The barrier/capping material may comprise at least one layer of material that prevents corrosion, diffusion or electromigration of layers, which are interfacing with said barrier/capping material. The barrier/capping material may be selected from the group comprising: Ti, TiN, TiW, Cr, Ni, NiB, NiP, NiCo NiBW, NiM-P, Pd, Pt, Au, Ag, W, Ru, Ta, TaN, Re, Os, Hf, Rh, Wo, Co, CoReP, CoP, CoWP, CoWB, CoWBP, alloys thereof and combinations thereof. The barrier/capping material may be applied by a method selected from the group comprising: electrodeposition, MOCVD, CVD, PVD, ALD, sputtering, electroless deposition, immersion deposition, electrografting and combinations thereof. The barrier/capping material may be applied with a mask-less selective deposition method, such as electroless deposition, wherein deposition is obtained only in surfaces active to said deposition process, such as on said structure layer and not on said arranged material layer. The said barrier/capping material may be used as a seed layer in said step a). The seed layer may be made of a material selected from the group comprising: Ru, Os, Hf, Re, Cr, Au, Ag, Cu, Sn, Ti, TiN, TiW, Ni, NiB, NiP, NiCo NiBW, NiM-P, Al, Pd, Pt, W, Ta, TaN, Rh, Wo, Co, CoReP, CoP, CoWP, CoWB, CoWBP alloys of these material, Si, conducting polymers such as polyaniline; solder materials, such as SnPb, SnAg, SnAgCu, SnCu; alloys, such as monel and permalloy; and alloys thereof and combinations thereof. The seed layer may be cleaned and activated, wherein said cleaning and activation comprise using organic solvents, such as acetone or alcohols; and/or inorganic solvents, such as nitric acid, sulfuric acid, phosphoric acid, hydrochloric acid, acetic acid, hydrofluoric acid; strong oxidizing agents, such as peroxides, such as hydrogen-peroxide; persulfates, such as sodium-persulfate or ammonium-persulfate; ferric-chloride; and/or oxygen plasma; argon plasma; hydrogen plasma; and/or by mechanically removing impurities.

In yet a further embodiment, the method may further comprise applying an adhesion layer before applying said seed layer and/or before applying said barrier/capping material; wherein said adhesion layer increase the adhesion of said seed layer or barrier/capping layer to said arranged material layer or structures. The adhesion layer may comprise at least one material selected from the group comprising: Cr, Ti, TiW, AP- 3000 (Dow Chemicals), AP-100 (Silicon Resources), AP-200 (Silicon Resources), AP-300 (Silicon Resources) and combinations thereof.

In a yet further embodiment, the forming of at least one electrochemical cell comprises a method for aligning said insulating pattern layer to a patterned layer on said substrate. The aligning method may comprise using alignment marks on the front side and/or backside of said master electrode, which marks are aligned to corresponding alignment marks on said substrate. The aligning method may be performed prior to forming at least one electrochemical cell. The formed electrochemical cell may comprise a solution of cations, such as copper or nickel ions, and anions, such as sulfate ions, for electrochemical plating. The electrolyte may comprise suppressors, levelers and/or accelerators, for instance PEG (poly-ethylene glycol) together with chloride ions and/or with SPS (bis- (3-sulfopropyl) -disulfide), MPSA and/or sodium-lauryl-sulphate.

In an embodiment, the structure layer may be a material selected from the group comprising: Au, Ag, Ni, Cu, Sn, Pb, SnAg, SnAgCu, AgCu and combinations thereof. The structure layer may comprise Cu or Ni. The anode material may be arranged onto said conducting electrode layer in the cavities of said insulating pattern layer using a method selected from the group comprising: electroplating, electroless plating, immersion plating, CVD, MOCVD, powder-coating, chemical grafting, electrografting and combinations thereof. The method for arranging said anode material may comprise electroplating or electroless plating. The forming of structures is stopped, by disconnecting said voltage, prior to dissolving all or substantially of the anode material. At least 5% of the anode material may be remaining when said forming of structures is stopped. The thickness of said plated structures may be controlled by monitoring the time and current passing through said at least one electrochemical cell.

In a further embodiment, the separation step d) may be performed by holding said substrate in a fixed position and moving said master electrode in a direction perpendicular to the substrate surface; or by holding said master electrode in a fixed position and moving said substrate in a direction perpendicular to the master electrode surface; or by performing the separation in a less parallel manner so as to ease the separation; or by a combination thereof. The step e) removing said seed layer may be performed by wet-etching, dry- etching, electrochemical etching or by combinations thereof.

In an embodiment, the method further comprises applying a protective coating which is covering all or substantially all of said seed layer, barrier/capping layer and/or structure layer; treating said protective coating with an anisotropic etch, thereby uncovering the top of said seed layer, barrier/capping layer and/or structure layer between the structures while leaving a protective layer on the side walls of said structures; removing said seed layer and/or barrier layer between said structures.

The material layer may be at least one layer of a dielectric material and may be applied by a method selected from the group comprising: spin-coating, spray-coating, powder-coating, dip-coating, roller-coating, sputtering, PVD, CVD, Plasma-Enhanced-Chemical-Vapor-Deposition (PECVD), electrodeposition, and combinations thereof. The material layer may be at least one layer of a metal and may be applied by a method selected from the group comprising: electrodeposition, MOCVD, CVD, PVD, ALD, sputtering, electroless deposition, immersion deposition, electrografting and combinations thereof. The dielectric material may comprise at least one layer of a material selected from the group comprising: low-k dielectric materials, ultra low-k dielectrics, dielectric materials with k-value less than 4, dielectric materials with k-value less than 2.5; organic compounds, insulating in-organic compounds, oxides, nitrides, polymer materials, polyimide, siloxane modified polyimide, BCB, SU-8, polytetrafluoroethylene (PTFE), silicones, elastomeric polymers, E-beam resists, ZEP (Sumitomo), photoresists, thinfilm resists, thickfilm resists, polycyclic olefins, polynorborene , polyethene, polycarbonate, PMMA, BARC materials, Lift-Off-Layer (LOL) materials, PDMS, polyurethane, epoxy polymers, fluoro elastomers, acrylate polymers, (natural) rubber, silicones, lacquers, nitrile rubber, EPDM, neoprene, PFTE, parylene, fluoromethylene cyanate ester, inorganic-organic hybrid polymers, (fluorinated and/or hydro'genated) amorphous carbon, organic doped silicon glass (OSG), fluorine doped silicon glass (FSG), PFTE/silicon compound, tetraethyl orthosilicate (TEOS), SiN, SiO2, SiON, SiOC, SiCN:H, SiOCH materials, SiCH materials, silicates, silica based materials, silsesquioxane (SSQ) based material, (nanoporous) methyl-silsesquioxane (MSQ), hydrogen- silsesquioxane (HSQ), TiO2, Al2O3, TiN and combinations thereof.

In a further embodiment, the method further comprises: arranging an etch-stop layer on top of the structures before the step f) of arranging the material. The etch-stop layer may comprise at least one layer of a material selected from the group comprising: SiC, SiN, films, low-k dielectric barrier/etch stop films, such as BLOk(TM); Ti, TiN, TiW, Cr, Ni, NiB, NiP, NiCo NiBW, NiM-P, Pd, Pt, Au, Ag, W, Ru, Ta, TaN, Re, Os, Hf, Rh, Wo, Co, CoReP, CoP, CoWP, CoWB, CoWBP, alloys thereof and combinations thereof. The material layer may be a porous low-k dielectric material and a pore sealing operation may be performed prior to applying further layers of material onto it.

In a further embodiment, the material layer may be a sacrificial polymer, wherein said sacrificial polymer is being decomposed into gaseous phase when treated with heat or radiation. The sacrificial polymer may be a copolymer of butylnorbornene and triethoxysilyl norbornene, such as Unity Sacrificial Polymer(TM) (Promerus).

### BRIEF DESCRIPTION OF DRAWINGS

Further objects, features and advantages of the- invention will appear from the following detailed description of several examples not being part of the invention, and embodiments, with reference to the drawings, in which:
Figs. 1 (a) to 1 (h) are schematic cross-sectional views disclosing several method steps of an example comprising etching, not being part of the invention.
Figs. 2 (a) to 2 (p) are schematic cross-sectional views disclosing several method steps of a first embodiment comprising plating.
Figs. 3 (a) to 3(l) are schematic cross-sectional views disclosing several method steps of an example comprising etching and in which a dielectric material layer is applied with a thickness of two layers, not being part of the invention.
Figs. 4 (a) to 4 (m) are schematic cross-sectional views disclosing several method steps of a second embodiment comprising plating and in which a dielectric material layer is applied with a thickness of two layers.
Figs. 5 (a) to 5(l) are schematic cross-sectional views disclosing several method steps of a third embodiment comprising plating and in which a dielectric material layer is applied with a thickness of two layers followed by plating also with a thickness of two layers.
Figs. 6 (a) to 6 (n) are schematic cross-sectional views disclosing several method steps of a fourth embodiment comprising plating and in which a dielectric material layer is planarized in two steps.
Figs. 7 (a) to 7 (b) are schematic cross-sectional views disclosing method steps of an example comprising plating and in which a via is filled with plating material, not being part of the invention.
Figs. 8 (a) to (b) are schematic cross-sectional views disclosing method steps of an example comprising plating and in which a via is filled with plating material, not being part of the invention.
Figs. 9 (a) to (c) are schematic cross-sectional views disclosing method steps of an example comprising plating and in which a via is filled with plating material, not being part of the invention.
Figs. 10 (a) to (c) are schematic cross-sectional views disclosing method steps of an example comprising plating and in which a via is filled with plating material, not being part of the invention.
Figs. 11 (a) to (c) are schematic cross-sectional views disclosing method steps of an example comprising plating and in which a via is filled with plating material, not being part of the invention.
Figs. 12 (a) to (b) are schematic cross-sectional views disclosing method steps of an example comprising plating and in which a via is filled with plating material, not being part of the invention.
Figs. 13 (a) to (c) are schematic cross-sectional views disclosing method steps of an example comprising plating and in which a via is filled with plating material, not being part of the invention.
Figs. 14 (a) to (c) are schematic cross-sectional views disclosing method steps of an example comprising plating and in which a via is filled with plating material, not being part of the invention.
Figs. 15 (a) to (b) are schematic cross-sectional views disclosing method steps of an example comprising plating and in which a conducting or non-conducting material is enclosed by a plating material, not being part of the invention.
Figs. 16 (a) to (d) are schematic cross-sectional views disclosing method steps of an example comprising plating and in which a conducting or non-conducting material is enclosed by a plating material, not being part of the invention.
Figs. 17 (a) to (h) are schematic cross-sectional views disclosing different examples of a master electrode.
Fig. 18 is a schematic flow scheme of the method steps of a conventional lithographic and electroplating process.
Fig. 19 is a schematic flow scheme of the method steps of the inventive method.
Fig. 20 (a) to (b) are schematic cross-sectional views disclosing an electrode having no predeposited material and an electrode having predeposited material, respectively.

### DETAILED DESCRIPTION OF EMBODIMENTS

Below, embodiments including the best mode of the invention will be described in great detail in order to enable a skilled person to carry out the invention. All embodiments described below comprise one or several of a number of method steps. Each of these steps will be described separately in detail below.

Generally, the method steps comprises one or several of the following six steps, namely:
a) arranging a seed layer on top of a substrate, or on top of a previous layer;
b) putting a master electrode in contact with the substrate, such as the seed layer, to form multiple electrochemical cells;
c) forming structures in said seed layer by plating;
d) removal of the master electrode;
e) removal of seed layer;
f) applying a dielectric material layer; and planarizing and/or patterning of the dielectric material layer.

In a first step (a) the substrate is prepared by applying a seed layer on top of said supplied substrate. In some embodiments, a barrier/capping and/or adhesion layer is deposited on the substrate prior to applying the seed layer or arranged below the seed layer before being applied on the substrate.

Said seed layer comprises at least one, normally relatively thin layer of conducing material onto which material, such as predeposited anode material in the master electrode, can be plated with the ECPR plating process.

Since the seed layer forms one of the electrodes of the electrochemical cell, the seed layer must be applied at least where a cell is to be formed. Moreover, the seed layer must be able to be electrically contacted from the outside of the substrate or through conducting parts of the substrate, which is connected with the seed layer,- or via the master electrode. Thus, the seed layer can be arranged covering only the required surfaces. However, the seed layer can be applied over the entire surface of the substrate to be acted upon.

The seed layer can be comprised of one or several layers of any of the materials Ru, Os, Hf, Re, Cr, Au, Ag, Cu, Sn, Ti, Ni, Al, alloys of these material, Si, other metals such as used for barrier/capping and/or adhesion layers mentioned below, conducting polymers such as polyaniline, solder materials such as SnPb, SnAg, SnAgCu, SnCu, alloys such as monel or permalloy and/or combinations thereof.

The seed layer can be applied by chemical-vapor- deposition (CVD), metallorganic-chemical - vapor-deposition (MOCVD), physical-vapor-deposition (PVD), atomic layer deposition (ALD), sputtering, electroless plating, electroplating, electro-grafting, immersion deposition and/br by other processes including applying layers of conducting material. When the seed layer is to be arranged on conducting as well as non-conducting areas of the substrate at the same time, vapor-deposition or sputtering techniques can be used. If the seed layer is to be relatively thick, electroplating may be used to form a layer having a relatively uniform upper surface independent on any recesses in the substrate surface. More in detail, a uniform upper surface can be achieved by using additives such as suppressors, levelers, accelerators and/or wetting agents, for instance PEG (poly-ethylene glycol) and chloride ions, SPS (bis- (3-sulfopropyl) - disulfide) and/or sodium-lauryl-sulphate used for copper plating, that increase the electrodeposition speed in the recess and/or by using pulse plating, for instance pulse-reverse-plating which also evens out height differences in the deposited layer. Using any application method, a uniform upper surface can be achieved independent on any recess in the substrate, specifically if the thickness of the seed layer is significantly larger than the depth of the recesses.

The seed layer of the substrate can be cleaned and activated before usage in the ECPR process. The cleaning method can include the use of organic solvents e.g. acetone or alcohols; and/or inorganic solvents e.g. nitric acid, sulfuric acid, phosphoric acid, hydrochloric acid, acetic acid, hydrofluoric acid, strong oxidizing agents, e.g. peroxides, persulfates, ferric-chloride, and/or de-ionized water. Cleaning can also be performed by applying oxygen plasma, argon plasma and/or hydrogen plasma or by mechanically removing impurities. Activation of the seed layer surface can be performed with solutions removing oxides, e.g. sulfuric acid, nitric acid, hydrochloric acid, hydrofluoric acid, phosphoric acid and etchants, e.g. sodium-persulfate, ammonium-persulfate, hydrogen-peroxide, ferric-chloride and/or other solutions comprising oxidizing agents.

Said barrier/capping layer can be comprised of at least one layer of at least one material or a combination of materials that: prevents said conducting material from corrosion; prevents said conducting material from diffusing into interfacing materials; prevents electro-migration and/or prevents other phenomena having negative effect on the electrical properties of the manufactured substrate. The barrier/capping layer can be comprised of Ti, TiN, TiW, Cr, Ni, NiB, NiP, NiCo NiBW, NiM-P, Pd, Pt, Au, Ag, W, Ru, Ta, TaN, Re, Os, Hf, Rh, Wo, Co, CoReP, CoP, CoWP, CoWB, CoWBP, alloys thereof and/or combinations thereof.

Said adhesion layer can be comprised of material or a combination of materials that increase the adhesion of the conducting seed layer material or barrier/capping material to the dielectric layer. The adhesion layer can be comprised of Cr, Ti, TiW, AP-3000 (Dow Chemicals), AP-100 (Silicon Resources), AP-200 (Silicon Resources) and/or AP-300 (Silicon Resources) . The adhesion layer can in some embodiments also function as a catalytic layer facilitating and/or improving the deposition of the seed layer. The barrier/capping and/or adhesion layers can be applied by using deposition methods such as electrodeposition, MOCVD, CVD, PVD, ALD, sputtering, electroless deposition, immersion deposition, electrografting and/or other deposition methods suitable for the barrier/capping and/or adhesion materials.

The barrier/capping layer and/or adhesion layer can, in some embodiments, be applied with a mask-less selective deposition process such as electroless deposition and/or chemical grafting, whereby deposition is obtained only on surfaces active in relation to said deposition processes, for instance on a structure layer and not on a dielectric layer.

In some embodiments the seed layer also functions as a barrier/capping layer, for instance when applying a Ru layer. In other embodiments, a barrier/capping layer can be used as a seed layer. In some embodiments, said barrier/capping layer needs to be activated in order to function as a seed layer. Such surface activation can be Sn, or Pd activation, for instance by treating the surface with a PdCl2 and/or SnCl2 solution. A solution for Pd activation can be PdCl2 in diluted HCI. In some embodiments, HF is added to the activation solution, for instance when activating a TiN barrier/capping layer.

In a second step (b) a master electrode comprising an electrically conducting electrode layer, of at least one inert material, such as platinum, and an insulating pattern layer, is put in close physical contact with the conducting top layer, such as the seed layer, on the substrate in the presence of an electrolyte, forming electrochemical cells, filled with electrolyte, defined by the cavities of the insulating structures on the master. Putting the master in close contact with the top layer on the substrate includes aligning the master electrode insulating pattern to the patterned layer on the substrate. This step can include the use of alignment marks on the front side or backside of the master electrode that can be aligned to the corresponding alignment marks on the substrate. The alignment procedure can be performed before or after applying the electrolyte. Predeposited anode material may previously be arranged onto said conducting electrode layer in the cavities of the insulating pattern layer prior to putting the master in contact with a substrate. Predeposited material in the master electrode cavities can be cleaned and activated in advance, in the same manner as described for the substrate seed layer in the first step "(a)", before putting the master into contact with the substrate.

Said electrolyte comprises a solution of cations and anions appropriate for electrochemical plating, such as conventional electroplating baths. For instance, when the ECPR plated structures are copper, a copper sulphate bath can be used, such as an acidic copper sulphate bath. Acidic may include a pH < 4, such as between pH=2 and pH=4. In some embodiments, additives can be used, such as suppressors, levellers and/or accelerators, for instance PEG and chloride ions and/or SPS. In another example, when the ECPR plated structures are Ni, a Watt's bath can be used. Appropriate electrolyte systems for different materials of ECPR plated structures are described in: Lawrence J. Durney, et al, Electroplating Engineering Handbook, 4th ed., (1984).

In a third step (c) structures of conducting material are formed using ECPR plating by applying a voltage, using an external power source, to the master electrode and to the seed layer on the substrate for creating an electrochemical process simultaneously inside each of the electrochemical cells defined by the cavities of the master electrode and the top layer on the substrate. When the voltage is applied in such a manner that the conducting electrode layer in the master electrode is anode and the seed layer of the substrate is cathode, the predeposited anode material inside the cavities of the master electrode is dissolved and at the same time material is deposited on the conducting layer on the substrate in the cavities that are filled with electrolyte. The deposited material on the conducting layer on the substrate forms structures that are a positive image of the cavities of the insulating pattern layer of the master electrode; and these structures are referred to as "ECPR plated structures" below in this description.

Said ECPR plated structures can be comprised of conducting materials, such as metals or alloys, for instance Au, Ag, Ni, Cu, Sn, Pb and/or SnAg, SnAgCu, AgCu and/or combinations thereof, for example Cu.

In one embodiment, said anode material is predeposited in the cavities of the master electrode by using ECPR etching of a material, which is anode, and depositing said material onto the conducting electrode, which is cathode, in the cavities of the insulating pattern layer of the master electrode. In other embodiments, said anode material is predeposited by regular electroplating, electroless plating, immersion plating, CVD, MOCVD, (charged) powder-coating, chemical grafting and/or electrografting said material selectively onto the conducting electrode layer in the cavities of the insulating pattern layer of the master electrode.

The voltage can be applied in a manner that improves the uniformity and/or properties of the plated structures. The applied voltage can be a DC voltage, a pulsed voltage, a square pulsed voltage, a pulse reverse voltage and/or a combination thereof.

The uniformity of the plated structures can be increased by choosing an optimized combination of applied voltage waveform, amplitude and frequency. The plating height can be controlled by monitoring the time and the current passing through the master electrode. If the total electrode area is known, the current density can be predicted from the current passing through the electrode area. The current density corresponds to a plating rate and hence the plating height can be predicted from the plating rate and time.

In some embodiments, the plating process is stopped by disconnecting the applied voltage before reaching the underlying surface of the dissolving anode material. For the plating process, this means that the process is stopped when a layer of predeposited anode material still remains, such as 5% to 50%, covering the conducting electrode layer. Otherwise, uneven current distribution may occur in the respective electrochemical cells.

In some embodiments, the desired height of the plated structures is significantly less than the thickness of the predeposited anode material. This implies that several layers of structures can be plated onto one or several substrates before having to predeposit new anode material. In some examples the height of the predeposited material can be at least twice as thick as the height of the plated structures. In some embodiments, multiple layers of ECPR plated structures are applied directly onto each other.

In a fourth step (d) after the ECPR plated structures are formed, the master is separated from the substrate in a manner that minimizes damages on the master or on the ECPR plated structures on the substrate. The method can be performed by holding the substrate in a fixed position and moving the master electrode in a direction perpendicular to the substrate surface or by holding the master electrode in a fixed position and moving the substrate in a direction perpendicular to the master electrode surface. In other embodiments, the separation can be performed in a less parallel manner in order to ease the separation.

In a fifth step (e) after ECPR plating, the seed layer on the substrate is removed so that the deposited structures are not connected to each other by the seed layer. The seed layer removing step can include applying wet etching chemicals suitable for globally etching the materials that the seed layer is comprised of. An anisotropic etching method can be used in order to avoid or reduce the etching of the sidewalls and/or undercutting of the ECPR plated structures. In some cases the seed layer can be removed with dry-etching, for instance ion-sputtering, reactive-ion-etching (RIE), plasma-assisted-etching, laser- ablation, ion-milling. Dry-etching may remove the material by evaporation and removal in gaseous form. In some embodiments, the seed layer can be removed by a combination of dry-etching and wet-etching methods. For instance, a dry-etching method can sometimes leave residues or bi-products from etching the seed layer. These residues or bi-products can in some embodiments be removed by wet-etching methods. One example is: when dry-etching copper, a bi-product is formed which can be rinsed away with a wet-etch method containing hydrochloric acid. In some embodiments, said seed layer removing step can include electrochemical etching methods by applying a voltage making the seed layer anode and thereby dissolving (etching) at least some portions of said seed layer. Said electrochemical etching methods can in some embodiments include ECPR etching of at least some portions of the seed layer. In some embodiments, a protective coating is applied uniformly all over said ECPR plated structures; said protective coating is treated with an anisotropic etch, said etch having the property of etching with a higher rate in a vertical direction than in lateral direction such as said dry- etching methods, thereby uncovering the top of said structures and/or the seed layer between the structures while leaving a protective layer on the side walls of said structures. In this case, the seed layer can be removed using said etching methods without etching the side walls and/or creating corner rounding of the ECPR plated structures. Said protective coating can comprise materials, and can be applied with methods, such as used for an etch-mask layer described below. Said protective coating on the sidewalls of said structures can be removed after finishing the seed layer etching. In the case that a barrier/capping layer and/or adhesion layer have been applied on the substrate prior to applying the seed layer, these layers can be removed in the areas between the ECPR plated structures using the same methods as mentioned above for the seed layer. In some cases, the seed layer, barrier/capping layer and/or adhesion layer are comprised of materials that can be selectively etched in relation to the material of the ECPR plated structures.

In some embodiments, said seed layer, barrier/capping layer and/or adhesion layer can be treated with methods converting said layers into insulating material. Such methods can for instance include: electrochemical anodization, such as anodizing a Ti layer to TiO2; thermal and/or plasma based treatment in an environment including gases or precursors, such as nitrogen and/or oxygen, that converts said layers into insulating layers; and/or chemical treatment for instance by strong oxidizing agents, such as peroxides and/or hydroxides. In this case, said layers being converted into insulating layers do not necessarily have to be removed.

After the ECPR plating step, remaining material deposited inside the cavities of the master electrode can be removed using the same methods as for removing the seed layer on the substrate. The remaining material can in some embodiments also be removed by regular plating and/or ECPR plating onto a cathode and/or dummy substrate, respectively. In some embodiments this is done prior to predepositing new material inside the cavities of the master used for the ECPR plating step. Alternatively, during plating, only a portion of the predeposited material may be used in a single procedure and another portion of the predeposited material may be used in the next procedure, for a number of procedures.

In a sixth step (f) a dielectric layer is applied onto the top layer of the substrate. In some embodiments, a barrier/capping layer and/or adhesion layer are applied onto the top layer of the substrate prior to applying said dielectric layer in order to improve the adhesion properties and/or prevent contamination, migration (electromigration) and/or diffusion of material; said barrier/capping layer and/or adhesion layer may be comprised of materials mentioned above and can be applied with methods described above. In some embodiments, said barrier/capping and/or adhesion layer can comprise materials such as for an etch-stop layer described below. Said dielectric layer can comprise one or several layers of materials with low dielectric constants.

The dielectric layer can be applied by spin-coating, spray-coating, powder-coating, dip-coating, roller-coating, sputtering, PVD, CVD, Plasma-Enhanced-Chemical-Vapor- Deposition (PECVD), electrodeposition, by other suitable deposition processes and/or by combinations thereof. The dielectric layer can be applied so that it completely covers the ECPR plated structures as well as fills up the cavities. The layer is applied as uniformly as possible in order to avoid or minimize the use of a planarization process. After application, a process can be performed to uncover the top of at least some parts of said structures from the dielectric layer. In an embodiment this is done by planarizing the dielectric layer to the same level as the top of said structures. Said planarization can be done by polishing and/or etching methods. The polishing methods can be mechanical and/or chemical. In some embodiments, chemical-mechanical- polishing (CMP) can be used. CMP includes planarizing the dielectric material using a mechanical force from a rotating or translating polishing pad together with a chemical component from a polishing slurry that is applied on the polishing pad which is put in close contact with the dielectric material or directly onto the material. The slurry chemistry is relevant for proper polishing. It can consist of micro or nano sized silica or aluminum particles in a carrier solution. During the CMP planarization, a chemical reaction occurs at the dielectric surface, which makes the surface susceptible to mechanical abrasion by the particles suspended in the slurry. The abraded particles are then swept away from the vicinity of the substrate surface and flushed from the system as fresh slurry is added and used slurry is removed from the system.

Another planarization method is to use a doctor blade.

A further planarization method is contact planarization (CP), which comprises applying a force or a pressure with a planar disc, which for instance is comprised of silicon, glass and/or quartz, onto a layer thereby reducing the unevenness of the layer surface. In some embodiments, a planarizing material layer is applied onto the dielectric layer prior to using said planarization methods. The planarizing material layer results in a more planar surface, than of the underlying layer, when applied. Said planarizing material layer can be applied with methods such as spin-coating, spray-coating, powder-coating, dip-coating, roller-coating, sputtering, PVD, CVD, PEVCD, electrodeposition and/or by combinations thereof. In some embodiments, the dielectric material and/or said planarization material layer is not cured prior to using said planarization methods which means that the material is in a more or less soft or flowable condition so that the material moves and planarize under the influence of the pressure. When using CP methods, said planar disc can be optically transparent, and UV-light and/or heat radiation can pass there through and be applied in order to cure said planarization material layer and/or dielectric layer. In other embodiments, the dielectric and/or planarizing material layer is brought into contact with said planar disc without applying a pressure. Thereafter, the dielectric and/or planarizing material layer can be heated (for example above the glass temperature T9) followed by applying a mechanical force by the planar disc onto the dielectric and/or planarizing material layer during sufficient time for planarization to occur. The heating may occur by having the disc at an elevated temperature or heating the disc. After releasing the pressure, the dielectric and/or planarizing material layer can be cooled (for example below T9) and the planar disc can be removed from the planarized surface.

In some embodiments, planarization using said etching methods (commonly referred to as etch-back methods) include dry-etching methods such as ion-sputtering, reactive-ion- etching (RIE), plasma-assisted-etching, laser-ablation, ion- milling and/or combinations thereof. Said etching methods may give a uniform etching rate over the entire surface that is planarized.

Planarization can in some embodiments be preformed by combining different planarization methods. In some cases it can be suitable first to use CMP and/or CP to planarize the top surface and then use said etching methods to further planarize or further remove said planarizing material layer and/or dielectric layer until it uncovers the top of the ECPR plated structures. The etching may be global or only affect the dielectric material. For instance, the planarization speed can be significantly higher on the dielectric material than on the ECPR plated structures. This minimizes the amount of abraded material from the ECPR plated structures during said planarization step. The structure material or metal may include an etch-stop layer or coating for preventing etching thereof. The etching can be continued until all structure portions are uncovered. The etching can be further continued in order to ensure that all structure portions are safely uncovered, such as less than about 20% extra, for example less than about 10%, for instance less than about 1%.

In some embodiments, end-point detection can be used to determine when said etching or planarization method is completed. The end-point detection method can comprise the use of a sensor that detects when the material of the ECPR plated structures is being abraded and/or etched by said planarization methods. The detection can be based on interferometry or spectral analysis of the etching plasma that detects molecules or atoms of the ECPR plated structures, which are abraded/etched by said etching or planarization methods. Other end detection methods may be used such as laser measurement of the height of the layer. Yet further end-point detection methods can include a sensor for analysis of the color of the planarized material, such as by using a camera, for example an LCD-camera.

In some embodiments, the tops of at least some parts of said structures are uncovered from the dielectric layer, which covers at least some parts of the structures, by patterning said dielectric layer with for example a lithographic process. Said lithographic process can be photolithography, laser lithography, E-beam lithography, nanoimprinting or other lithographic processes suitable for the dielectric material.

In another embodiment, at least some parts of the top of said structures as delimited by an etch-mask, are uncovered by dry-etching the dielectric layer with methods such as ion-sputtering, reactive-ion-etching (RIE), plasma-assisted-etching, laser-ablation, ion-milling. The patterned material used as an etch-mask for the dry-etching process can be a photoresist and/or another polymer material that can be patterned by said lithographic processes. The etch-mask material for dry-etching the dielectric layer can also comprise materials such as SiN, SiO2, SiC, tetraethyl orthosilicate (TEOS), SiON, SiOC, SiCN:H, (non-porous) fluorine doped silicon glass (FSG), (non-porous) organic doped silicon glass (OSG), a low-k dielectric barrier/etch stop film such as BLOk(TM) (Applied Materials), Pt, Ti, TiW, TiN, Al, Cr, Au, Ni, Cu, Ag, other metals, other hard materials and/or combinations thereof. The etch-mask material can in turn be etched using a patterned photoresist and/or another resist, which is patterned with said lithographic processes, as a mask. In some embodiments, the etch-mask can comprise at least one layer of ECPR plated structures. In some embodiment, said etch-mask is removed after the etching step. However, in other embodiments, such as when the etch-mask comprise and insulating material, removing the etch-mask is not required, for instance in order to improve mechanical properties of the multilayer structure.

In some embodiments, said dielectric layer can be applied with a thickness corresponding to multiple structure layers and patterned in several layers prior to applying at least one structure layer. Alternatively, said dielectric layer can be applied and patterned repeatedly, thereby creating a patterned dielectric layer with a thickness corresponding to multiple structure layers, prior to applying at least one structure layer.

In all embodiments, the method for uncovering at least some parts of the ECPR plated structures from the dielectric material can include a combination of said planarization methods and said patterning methods.

In some embodiments, the dielectric materials can be comprised of materials having dielectric constants less than 4.0. Such materials are generally referred to as low-k materials. The low-k materials can comprise carbon-doped dielectrics, such as OSG, FSG, organic polymers, and the like. In other embodiments, ultra-low-k dielectric materials can be used with a k-value ranging from less than 2.5. For all embodiments, the dielectric material can be comprised of organic compounds, such as polymers, as well as insulating inorganic compounds such as oxides and/or nitrides. Used polymer materials can for instance be: polyimide, siloxane modified polyimide, BCB, SU-8, polytetrafluoroethylene (PTFE), silicones, elastomeric polymers, E-beam resists (such as ZEP (Sumitomo)), photoresists, thinfilm resists, thickfilm resists, polycyclic olefins, polynorborene , polyethene, polycarbonate, PMMA, BARC materials, Lift-Off-Layer (LOL) materials, PDMS, polyurethane, epoxy polymers, fluoro elastomers, acrylate polymers, (natural) rubber, silicones, lacquers, nitrile rubber, EPDM, neoprene, PFTE, parylene, fluoromethylene cyanate ester, inorganic-organic hybrid polymers, (fluorinated and/or hydrogenated) amorphous carbon, by other polymers and/or by combinations thereof. Used inorganic compounds can for instance be organic doped silicon glass (OSG), fluorine doped silicon glass (FSG), PFTE/silicon compound, tetraethyl orthosilicate (TEOS), SiN, SiO2, SiON, SiOC, SiCN:H, SiOCH materials, SiCH materials, silicates, silica based materials, silsesquioxane (SSQ) based material, (nanoporous) methyl-silsesquioxane (MSQ), hydrogen- silsesquioxane (HSQ), TiO2, Al2O3, TiN and/or combinations thereof.

Said dielectric material can also comprise other available low-k dielectrics listed in the publication: K. Maex, M. R. Baklanov, D. Shamiryan, F. lacopi, S. H. Brongersma, Z. S. Yanovitskaya, J. Appl. Phys . 93, 8793 (2003).

In some embodiments, an etch-stop layer is deposited onto the top layer on the substrate prior to applying the dielectric layer. The etch-stop material can be comprised of a material that is much less effected by said dry-etching processes than the dielectric material, and which can be used for selectively etch cavities in the dielectric layer down to the underlying etch-stop layer on top of underlying layer of the substrate or etch down the dielectric layer to slightly below the top of the structure layer. For instance, the etch- stop material can be comprised of SiC, SiN, Pt and/or TiW films. A low-k dielectric barrier/etch stop film, such as BLOk(TM) may be used. Material used for said barrier/capping, adhesion and/or etch-mask layer may also be used for the etch- stop layer. This silicon carbide film is deposited using trimethylsilane ((CH3) 3SiH) and has a lower dielectric constant (k < 5) than that of conventional SiC films (k > 7) generated by SiH4 and CH4, and that of plasma silicon nitride (k > 7). In some embodiments, said etch-stop layer can also function as a barrier/capping layer and/or adhesion layer, which adhesion layer also may improve the adhesion between the lower dielectric layer and the upper dielectric layer.

In some aspects, for instance when the dielectric material is a porous ultra low-k dielectric material, a pore sealing operation can be done prior to applying any material layer onto the dielectric. In other embodiments, said dielectric material can be a sacrificial polymer material wherein the sacrificial polymer is decomposed into a gaseous phase when for instance treating the material with heat or radiation. In this case, said dielectric material can be removed, by decomposing said material and allowing the byproducts to diffuse away, after the multiple structure layers are formed and thereby creating voids or air gaps in the areas that were occupied by the dielectric layer. Said sacrificial polymer used can be a copolymer of butylnorbornene and triethoxysilyl norbornene, such as Unity Sacrificial Polymer(TM) (Promerus). Further more, by using mechanically stable and insulating barrier/capping and/or etch-mask layers that are not removed from the multiple structure layers, said multiple structure layers are prevented from collapsing.

In some embodiments, forming multiple layers of conducting and/or dielectric materials includes creating at least one layer with ECPR plating and creating at least another layer with known masking and deposition techniques such as lithography followed by electrodeposition, electroless deposition, wet etching, dry etching or other methods for creating a patterned layer of a conducting material.

Below, several of the method steps for producing a multilayer substrate will be disclosed on the drawings, which show several embodiments of the method steps.

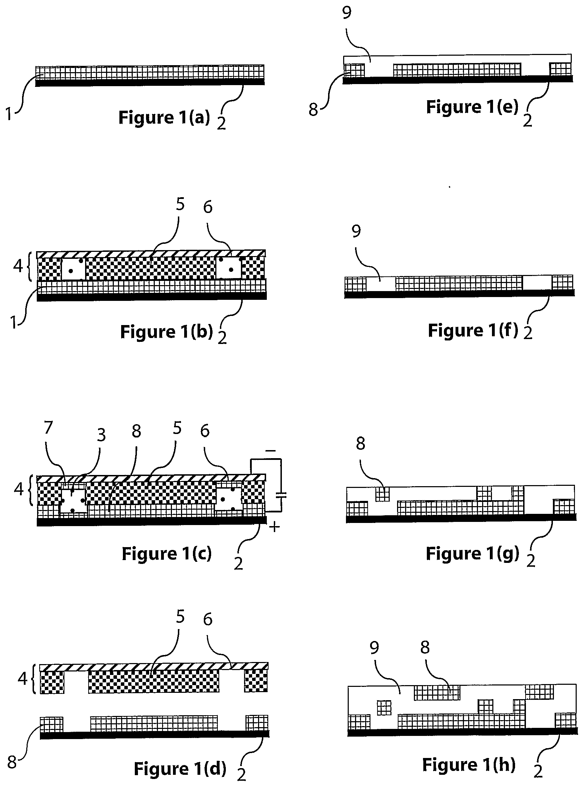

Figures 1 (a) to (h) illustrate the steps for producing a substrate comprising multiple layers of ECPR etched structures and multiple layers of planarized dielectric material.

Figure 1 (a) illustrates a substrate 2 onto which a seed layer 1 has been applied with the method in said step "(a)".

Figure 1 (b) illustrates how the master electrode 4 is aligned to and put in contact with the seed layer 1 on the substrate 2 in the presence of an electrolyte 3 with the method in said step "(b)".

Figure 1 (c) illustrates how ECPR etching proceeds with the method in said step "(c)". ECPR etched structures 8, which is a replica (negative image) of the insulating pattern layer 5 of the master electrode 4, are formed in the seed layer on the substrate 2. The etched material 7 is deposited on the conducting electrode layer 6 in the cavities of the master electrode. The ECPR etching process is stopped when the etching has removed the entire thickness of the seed layer 1. The etching can be stopped before or prior to etching the entire thickness of the seed layer.

Figure 1 (d) illustrates the substrate with ECPR etched structures 8 after separating the master electrode 4 from the substrate 2 with the method in said step "(d)". Possible residues or particles or portions of the seed layer have been removed in the etched grooves. Moreover, the material 7 deposited inside the cavities of the master electrode has been removed, such as according to the method in said step "(e)".

Figure 1 (e) illustrates how a dielectric material 9 has been applied with the method in said step "(f)" and covers the ECPR etched structures 8.

Figure 1 (f) illustrates how the dielectric material 9 has been planarized with the method in step "(f)"/ uncovering the top of the ECPR etched structures 8.

Figure 1 (g) illustrates how a second seed layer has been applied with the method in said step "(a)", how ECPR etched structures 8 has been formed by etching grooves in the seed layer with the method in "(b)" to "(e)" and how a second layer of dielectric material 9 has been applied and planarized, with the method in said step "(f)", uncovering the top of the ECPR etched structures.

Figure 1 (h) illustrates how multiple layers of ECPR etched structures 8 and planarized dielectric material 9 have been formed on the substrate 2 by repeating said steps "(a)" to "(f)".

If polishing is used in the planarization steps of Figures 1 (f) and 1 (h), the polishing is performed on both the hard structural material 8, such as of metal, as well as on the soft dielectric material 9. This can result in dishing and erosion as explained above. The dishing and erosion problems are directly related to the amount of structure material that is planarized. By carefully controlling the thickness of the structure layer, by using a master electrode with predeposited anode material, dishing, erosion and overall planarity problems can be significantly reduced or even eliminated.

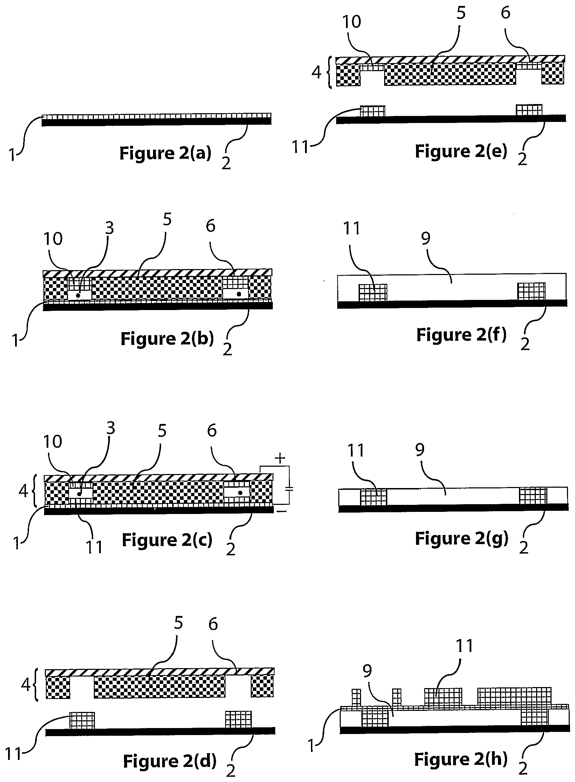

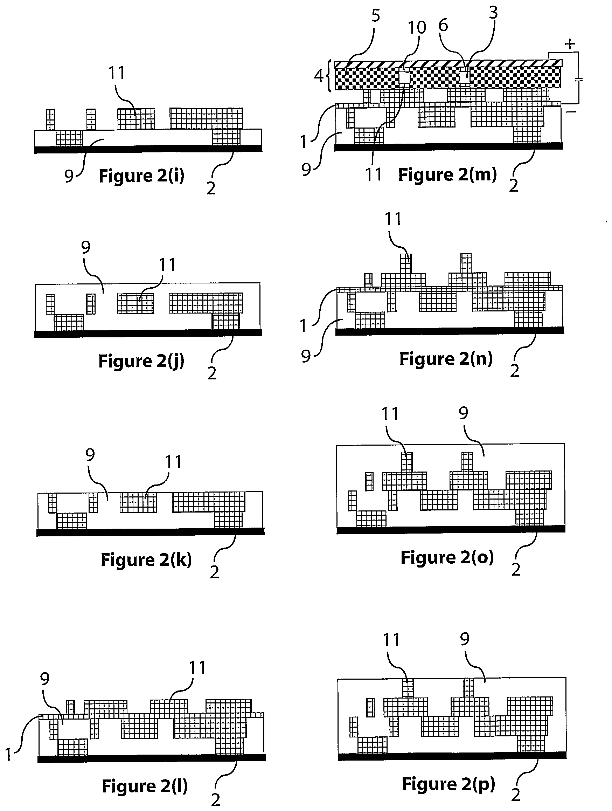

Figures 2 (a) to 2 (p) illustrate the steps for producing a substrate comprising multiple layers of ECPR plated structures and multiple layers of planarized dielectric material.

Figure 2 (a) illustrates a substrate 2 onto which a seed layer 1 has been applied with the method described in said step "(a)".

Figure 2 (b) illustrates how the master electrode 4 is aligned to and put in contact with the seed layer 1 on the substrate 2 in the presence of an electrolyte 3 with the method in said step "(b)". Figure 2 (c) illustrates ECPR plating with the method in said step "(c)". An anode material 10, which is previously predeposited onto the conducting electrode layer 6 in the cavities formed in the insulating pattern layer 5 of the master electrode 4, is dissolved and transported in the electrolyte 3 at the same time as ECPR plated structures 11 are formed onto the seed layer 1 on the substrate 2 creating a pattern which is a replica (positive image) of the cavities of the master electrode. Figure 2 (d) illustrates the substrate 2 with ECPR plated structures 11 after separating the master electrode 4 from the substrate 2 with the method in said step "(d)" and after removing the seed layer in the cavities between the ECPR plated structures with the method described in said step "(e)". All or substantially all of the anode material, which had been predeposited in the cavities of the master, has been transferred to the substrate forming the ECPR plated structures. Remaining residues of predeposited material in the master can be removed according to the methods described in said step "(e)".

Figure 2 (e) illustrates an alternative to Figure 2 (d) showing the substrate with ECPR plated structures 11 after separating the master 4 from the substrate 2 with the method in said step "(d)" and after removing the seed layer in the cavities between the ECPR plated structures with the method described in said step "(e)". Only a portion of the anode material 10, which had been predeposited in the cavities of the master, has been transferred to the substrate forming the ECPR plated structures. The remaining predeposited anode material can be used for one or several subsequent ECPR plating steps or it can be removed from the cavities by using the methods described in said step "(e)". In some embodiments, the remaining anode material does not need to be removed before predepositing new anode material for using in a subsequent ECPR plating step.

Figure 2 (f) illustrates how a dielectric material 9 has been applied with the method in said step "(f)" and covering the ECPR plated structures 11 on a substrate 2.

Figure 2 (g) illustrates how the dielectric material 9 has been planarized with the method in said step "(f)", uncovering the top of the ECPR plated structures 11 on the substrate 2. If a polishing method is used, the polishing will be performed on structures having different hardness, such as the hard structure layer, such as of metal and the soft material layer of dielectric material. This can result in dishing and erosion of the soft material and crack formation on the structure layer. The dishing and erosion problems are directly related to the amount of structure material that is planarized. By carefully controlling the thickness of the structure layer, by using a master electrode with predeposited anode material, dishing, erosion and overall planarity problems can be significantly reduced or even eliminated.

Figure 2 (h) illustrates how a second seed layer 1 has been applied with the method in said step "(a)" and how a second layer of ECPR plated structures 11 is formed by plating a pattern, which is a replica of the cavities of the master electrode, onto the seed layer 1 with the methods in said steps "(b)" to "(e)".

Figure 2 (i) illustrates how the seed layer in the cavities between the ECPR plated structures is removed with the method described in said step "(e)".

Figure 2(j) illustrates how a dielectric material 9 has been applied with the method in said step "(f)" and covering the ECPR plated structures 11 on substrate 2.

Figure 2 (k) illustrates how the dielectric material 9 has been planarized with the method in said step "(f)", uncovering the top of the ECPR plated structures 11 on the substrate 2.

Figure 2 (I) illustrates how a third seed layer 1 has been applied with the method in said step "(a)" and how ECPR plated structures 11 has been formed by plating a pattern, which is a replica of the cavities of the master electrode, onto the seed layer 1 with the methods in said steps "(b)" to "(e)".

Figure 2 (m) illustrates how a fourth layer of ECPR plated structures 11 is formed onto at least some parts of the previously plated pattern without having removed the previously applied seed layer 1. The master electrode 4 is aligned to and put in contact with the underlying pattern with the methods in said step "(b)" in a way that the cavities of the insulating layer 5, which are enclosing the electrolyte 3, are placed only in the areas which are to be plated upon. When the plating voltage is applied, the predeposited anode material 10 is dissolved from the conducting electrode layer 6 in the cavities of the master and ECPR plated structures 11 are formed by the method described in said step "(c)". This step can only be performed if at least some parts of the fourth structure layer are completely inside the structure layer of the previous layer, and results in a saving of method steps.

Figure 2 (n) illustrates a substrate 2 onto which a fourth layer of ECPR plated structures 11 have been deposited directly onto at least some parts of the second ECPR plated pattern without removing the seed layer 1 which had been applied prior to forming the third layer of ECPR plated structures.

Figure 2 (o) illustrates how the seed layer has been removed with the method in said step "(e)" and how a further layer of dielectric material 9 has been applied and covering the ECPR plated structures 11 on substrate 2.

Figure 2 (p) illustrates how the dielectric material 9 has been planarized using the method in step "(f)" uncovering the top of the ECPR plated structures 11.

If a polishing method is used, the polishing will be performed on two layers having different hardness, such as the hard structure layer of metal and the soft material layer of dielectric material. This can result in dishing and erosion of the soft material and crack formation on the structure layer. The dishing and erosion problems are directly related to the amount of structure material that is planarized. By carefully controlling the thickness of the structure layer, by using a master electrode with predeposited anode material, dishing, erosion and overall planarity problems can be significantly reduced or even eliminated.

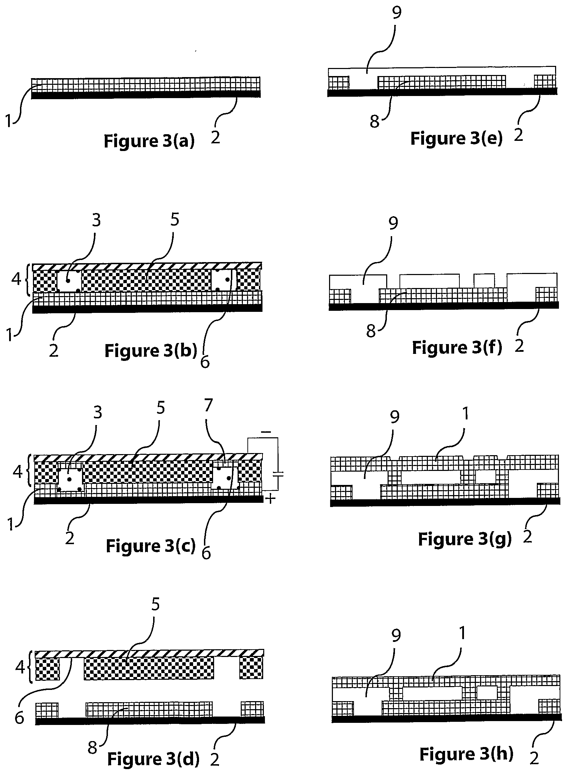

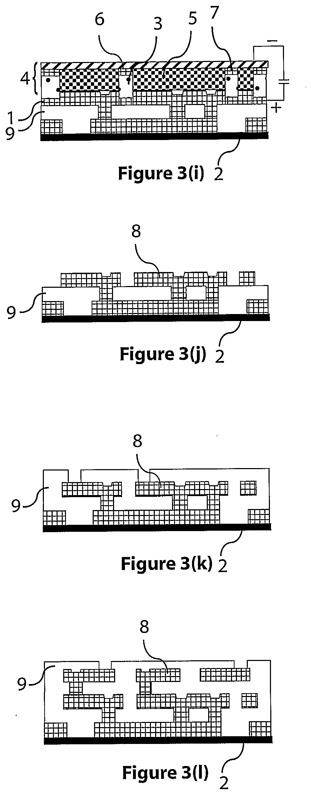

Figures 3 (a) to 3 (k) illustrate the steps for producing a substrate comprising multiple layers of ECPR etched structures and multiple layers of lithography patterned dielectric material. In this example, several procedure steps are saved because the dielectric material is formed with a thickness corresponding to two layers at the same time. In addition, two structure layers are formed in a single process, thus saving further time, by applying a seed layer of a thickness corresponding to two layers.

Figure 3 (a) illustrates a substrate 2 on which a seed layer 1 is arranged with the method in said step" (a) ". Figure 3 (b) illustrates a master electrode 4 that is aligned and put into contact with a seed layer 1 on a substrate 2 using the methods in said step " (b) " and where an electrolyte 3 is enclosed in the cavities of the insulating layer 5 of the master. Figure 3 (c) illustrates how ECPR etched structures are formed in the seed layer 1 on a substrate 2 by using the methods described in said step " (c) ". The etched material 7 is transferred in the electrolyte 3 and deposited onto the conducting electrode layer 6 in the cavities of the insulating layer 5 in the master electrode 4.

Figure 3 (d) illustrates a substrate 2 with ECPR etched structures 8 after separating the master 4 from the substrate with the method in said step " (d) " and after removing possible residues or particles of the seed layer 1 in the etched grooves. Also the material deposited inside the cavities of the master electrode has been removed according to the method in said step "(e)".

Figure 3 (e) illustrates how a dielectric material 9 has been applied to a substrate 2 with the method in step "(f)" and is covering the ECPR etched structures 8. The material is applied in a thickness corresponding to two layers. Several of the above mentioned methods for applying a dielectric layer, such as spin-coating or spray-coating, can give a substantially planar surface without recesses being formed. Alternatively, a planarization material layer can be applied as described in step "(f)". However, small valleys may still be formed opposite the cavities in the structure layer 8 below. Such small valleys do not mean any problem in this process. If necessary, the dielectric material layer is planarized with for example contact planarization. Alternatively, polishing methods can be used, since a single material is affected, namely the material of the dielectric layer. In some cases, contact planarization and/or polishing methods can be combined with said etch-back methods to achieve desired planarization.

Figure 3 (f) illustrates how the dielectric material 9 is patterned by lithographic methods in said step "(f)", uncovering the top of at least some parts of the ECPR etched structures 8 previously formed on the substrate 2.

Figure 3 (g) illustrates a second seed layer 1 that is applied using the methods in said step "(a)" onto the lithography patterned dielectric material 9 which previously is applied to the substrate 2. The second seed layer is applied with a thickness sufficient for two layers. In some cases, the cavities of the dielectric material below cause the formation of grooves on top of the applied seed layer corresponding to the pattern, as shown in the figure. Such grooves do not cause any problem for the present process. As mentioned above, electroplating methods including the used of additives, such as mentioned above, and/or pulse plating can be used to apply the relatively thick seed layer with a uniform upper surface independent on any recesses in the underlying layer. Using any application method, a uniform upper surface can be achieved independent on any recess in the substrate if the thickness of the seed layer is significantly larger than the depth of the recess. Figure 3 (h) illustrates how the grooves of the seed layer 1 is removed, if desired, with the planarization methods such as for a dielectric material which is described in said step "(f)". Since the planarization works on a single material, in this case the hard material of the seed layer, any polishing method can be used. As mentioned above, this planarization can in some cases be left out. Figure 3 (i) illustrates how the master electrode 4 is aligned and put in contact with the second seed layer 1 using the methods in said step "(b)". Electrolyte 3 is enclosed in the cavities of insulating pattern layer 5. The figure also illustrates how structures are formed by ECPR etching according to the method in said step "(c)", whereby the etched material 7 is being deposited on the conducting electrode layer 6 in the cavities of the master electrode.

Figure 3(j) illustrates how a second layer of ECPR etched structures 8 is formed after separating of the master electrode from the substrate 2 using the method in said step "(d)" and after removing possible residues of seed layer in the grooves of the ECPR etched structures using the method in said step "(e)".

Figure 3 (k) illustrates a second dielectric material 9 that is applied with a thickness of two layers and patterned with lithography on the second layer of ECPR etched structures 8 using the methods in said step "(f)".

Figure 3 (I) illustrates how a third seed layer 1 is applied, with a thickness of two layers, with the method in "(a)", how ECPR etched structures 8 is formed by repeating the methods in said steps "(b)" to "(e)" and how a dielectric material 9 is applied and further patterned with lithography using the method in said step "(f)". These processes are repeated until the entire structure is built.

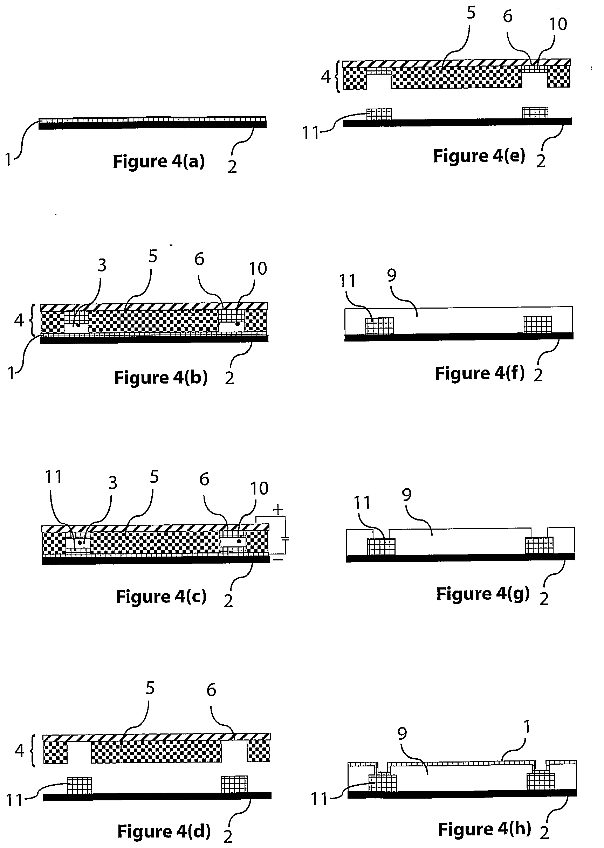

Figures 4 (a) to 4 (m) illustrate the steps for producing a substrate comprising multiple layers of ECPR plated structures and multiple layers of lithography patterned dielectric material.

Figure 4 (a) illustrates a substrate 2 onto which a relatively thin seed layer 1 is applied with the method described in said step "(a)".

Figure 4 (b) illustrates how the master electrode 4 is aligned and put in contact with the seed layer 1 on the substrate 2 in the presence of an electrolyte 3, which is enclosed in the cavities of the insulating pattern layer 5, with the method in said step "(b)".

Figure 4 (c) illustrates how ECPR plating proceeds with the method in said step "(c)". An anode material 10, which is previously predeposited onto the conducting electrode layer 6 in the cavities exerted by the insulating pattern 5 of the master electrode 4, is dissolved and transported in the electrolyte 3 at the same time as ECPR plated structures 11 are formed onto the seed layer 1 on the substrate 2 creating a pattern which is a replica (positive image) of the cavities of the master electrode.

Figure 4 (d) illustrates the substrate 2 with ECPR plated structures 11 after separating the master electrode 4 from the substrate 2 with the method in said step "(d)". The seed layer in the cavities between the plated structures is removed with the method described in said step "(e)". All or substantially all of the anode material, which is predeposited in the cavities of the master, is transferred to the substrate forming the ECPR plated structures. Remaining residues of predeposited material in the master is removed according to the methods described in said step "(e)".

Figure 4 (e) illustrates an alternative to Figure 4 (d) showing the substrate with ECPR plated structures 11 after separating the master electrode 4 from the substrate 2 with the method in said step "(d)" and after removing the seed layer in the cavities between the plated structures with the method described in said step "(e)". Only a portion of the anode material 10, which is predeposited in the cavities of the master, is transferred to the substrate forming the ECPR plated structures. The remaining predeposited anode material can be used for one or several subsequent ECPR plating steps or can be removed from the cavities by using the methods described in said step "(e)". In some embodiments, the remaining anode material does not have to be removed before predepositing new anode material for using in a subsequent ECPR plating step.

Figure 4 (f) illustrates how a dielectric material 9 has been applied with the method in said step "(f)" and covering the ECPR plated structures 11 on a substrate 2 and having a height corresponding to two layers. The dielectric material layer can be planarized if required.

Figure 4 (g) illustrates how the dielectric material 9 is patterned by said lithography and/or etching methods in step "(f)", uncovering the top of at least some parts of the ECPR plated structures 11 previously formed on the substrate 2.

Figure 4 (h) illustrates a relatively thin seed layer 1 that is applied using the method in said step "(a)" onto the dielectric material 9.

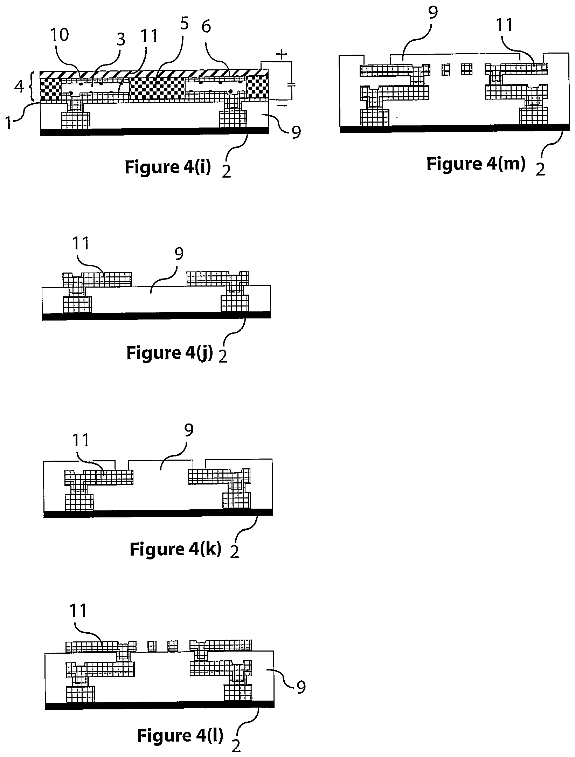

Figure 4 (i) illustrates a master electrode 4 that is aligned and put in contact with the seed layer 1 using the methods in said step "(b)". By using the method in said step "(c)", a second layer of ECPR plated structure 11 is formed inside the cavities of the insulating pattern layer 5 as well as in the cavities of patterned dielectric material 9 by dissolving the predeposited anode material 10 which is transported in the electrolyte 3 and deposited on the seed layer. At the same time, a third layer is formed by deposition. The third layer can include with small recesses opposite the cavities in the second dielectric layer, as shown. Such recesses normally mean no problem in the process. Recesses can also be minimized by the use of pulse-plating, such as pulse-reverse-plating, and/or by including additives in the electrolyte such as mentioned above. If necessary, the recesses can be removed by a planarization operation, which can be a polishing operation since only hard material is encountered, namely the deposited material, such as a metal.

Figure 4(j) illustrates a third layer of ECPR plated structures 8 being finalized after separation of the master electrode using the method in said step "(d)". The seed layer is removed in the areas between the ECPR plated structures using the method in said step "(e)". The second layer of ECPR plated structures fill up the cavities of the lithography patterned dielectric material 9 and connect to the first layer of underlying structures and forms at the same time a third structure layer.

Figure 4 (k) illustrates a second layer of dielectric material 9 that is applied with a thickness of two layers and patterned with lithography and/or etching on a second layer of ECPR etched structures 8 using the methods in said step "(f)".

Figure 4(l) illustrates how a fourth and fifth layer of ECPR plated structures 11 are formed by repeating the methods in step "(a)" to "(e)". At lest some portion of the ECPR plated structures connect to at least some parts of the underlying structures through the cavities of the lithography patterned dielectric material 9.

Figure 4 (m) illustrates how a further layer of dielectric material 9 with a thickness of two layers is applied and patterned on the third layer of ECPR plated structures 11 using the method in said step "(f)".

The process is repeated until the desired number of layers is built.

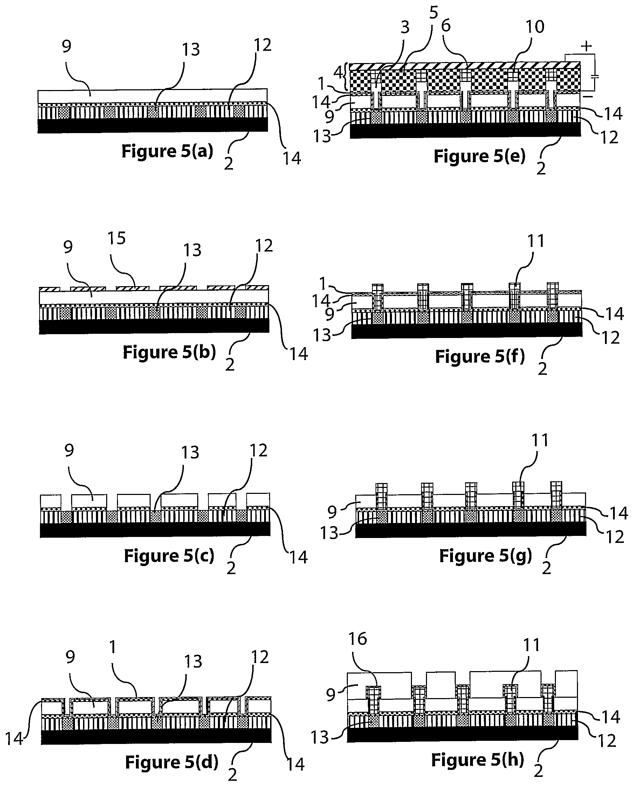

Figures 5 (a) to 5 (l) illustrate the steps for producing a substrate comprising multiple layers of ECPR plated structures including barrier/capping layers and multiple layers of lithography patterned dielectric material.

ECPR plating can be used for creating metallic interconnects in semiconductor device. A substrate 2 is patterned with a pre-metal dielectric 12, which is arranged covering possible semiconductors or transistors formed in the substrate. The cavities or the pattern are filled for creating connection plugs 13 of a suitable material, for instance tungsten. A first barrier/capping layer 14 is applied onto the connection plugs 13 and the pre-metal dielectric layer 12. The barrier/capping layer can be of the same materials and can be applied with the same methods as described for the barrier/capping layers in said step "(f)"- On top of the barrier/capping layer, a first layer of dielectric material 9 is applied with methods in said step "(f)". The dielectric material may comprise a suitable low-k or ultra low-k material, also described in said step "(f)". The result of performing the mentioned steps is shown in Figure 5 (a).

Figure 5 (b) illustrates an etch-mask 15 that is applied and patterned on top of the dielectric material 9. In some embodiment, said etch-mask is removed after the etching step. However, in other embodiments, such as when the etch-mask comprise and insulating material, removing the etch-mask is not required, for instance in order to improve mechanical properties of the multilayer structure.

Figure 5 (c) illustrates how the dielectric material 9 and the barrier/capping layer 14 are patterned by the lithography and/or etching methods in said step "(f)" thereby uncovering the top of the connection plugs 13 forming cavities down to the connection plug 13.

Figure 5 (d) illustrates how a barrier/capping layer 14 and a seed layer 1 is applied onto, and into the cavities of, the patterned dielectric material 9 using the method in said step "(a)". The barrier/capping layer can also functions as a seed layer, e.g. when using a Ru layer.

Figure 5 (e) illustrates how a master electrode 4 is aligned to the patterned dielectric material 9 and put in contact with the seed layer 1 and enclosing electrolyte 3 in the cavities of the insulating pattern layer 5 using the method in step "(b)". When applying a voltage the predeposited anode material 10 is dissolved at the conducting electrode layer 6 and ECPR plated structures are deposited on the seed layer 1 in the cavities that are filled with electrolyte 3, as described in the method in said step "(c)".

Figure 5 (f) illustrates how two layers of ECPR plated structures 11 are formed in one step where the first is filling the cavities of the dielectric material 9 and the second is forming lines on top of some parts of the dielectric material 9. Alternatively, the via can first be filled by ECPR plating using the methods in said steps "(b)" to "(d)" and then ECPR plated structures 11 are deposited on top on the via layer by repeating the methods in said steps "(b)" to "(d)" and without removing the seed layer in between, possibly by using a second master electrode with a different pattern.

Figure 5 (g) illustrates how the seed layer and the barrier/capping layer selectively are removed in the areas between the ECPR plated structures 11 using the method in said step "(e)". An anisotropic etching method can be used in order to avoid or reduce the etching of the sidewalls and/or undercutting of the ECPR plated structures 11. The seed layer and/or the capping layer can be of a material that can be selectively etched in relation to the material of the ECPR plated structures 11. Alternatively, said seed layer and/or barrier/capping layer can be treated with methods, such as anodization methods mentioned above, converting said materials into insulating materials. In this case, removing said layers may not be required.

Figure 5 (h) illustrates how a barrier/capping coating 16 selectively is applied on the ECPR plated structures. Moreover, a second layer of dielectric material 9 is applied with a thickness of two layers and patterned with lithography, using the method in said step "(f)". The deposition of this barrier/capping coating can be done with a method that selectively deposits the material only onto the ECPR plated conductive structures as described in the method in said step "(f)" and does not deposit material on the non-conductive dielectric material 9. The deposition process can for instance be an electroless deposition process mentioned below and the material can for instance be CoWP, CoWB or CoWBP. In some embodiments, the barrier/capping coating is removed, using said etching methods, in the bottom of the cavities of the applied dielectric layer 9 in order to achieve a better contact to a subsequent structure layer.

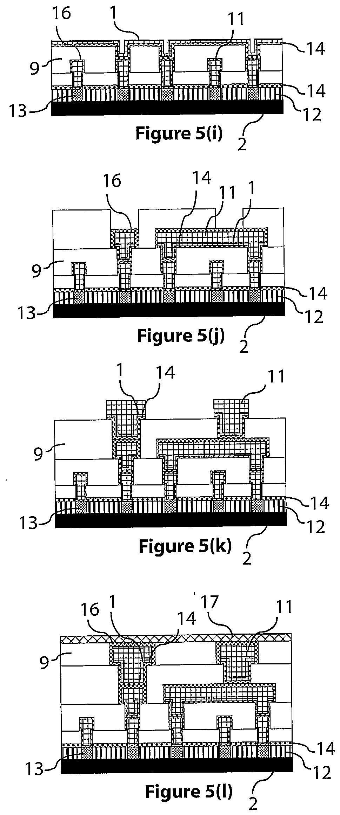

Figure 5(i) illustrates how a barrier/capping layer 14 and a seed layer 1 is applied on top of and into the cavities of the patterned dielectric material 9, using the method in said step "(a)".

Figure 5(j) illustrates how the cavities of the dielectric material 9 is filled and how another wire layer of ECPR plated structures 11 is simultaneously formed on top of the dielectric material by repeating the methods in said steps "(b)" to "(d)". The seed layer and the barrier/capping layer are selectively removed in the areas between the ECPR plated structures 11 using the method in said step "(e)". A barrier/capping coating 16 is selectively applied onto the ECPR plated structures and a dielectric material is applied and patterned, using the method in said step "(f)".

Figure 5 (k) illustrates the result after applying a barrier/capping layer 14 and a seed layer 1 using the method in said step "(a)" ; forming ECPR plated structures that fill up the cavities of the patterned dielectric material 9 and forming a wire layer of ECPR plated structures 11 on top of the dielectric material by repeating the methods in said steps "(b)" to "(d)"; and removing the barrier/capping layer and seed layer from the areas between the ECPR plated structures using the method in said step "(e)".

Figure 5(l) illustrates how another layer of barrier/capping coating 16 is applied onto the ECPR plated structures 11 and how a dielectric material 9 is applied and patterned and/or planarized to uncover the top of the plated structures using the method in said step "(f)".

Finally, a passivation layer 17 is applied on top of the ECPR plated structures and dielectric material 9. The passivation layer can be one or several barrier/capping layers and/or dielectric material layers.

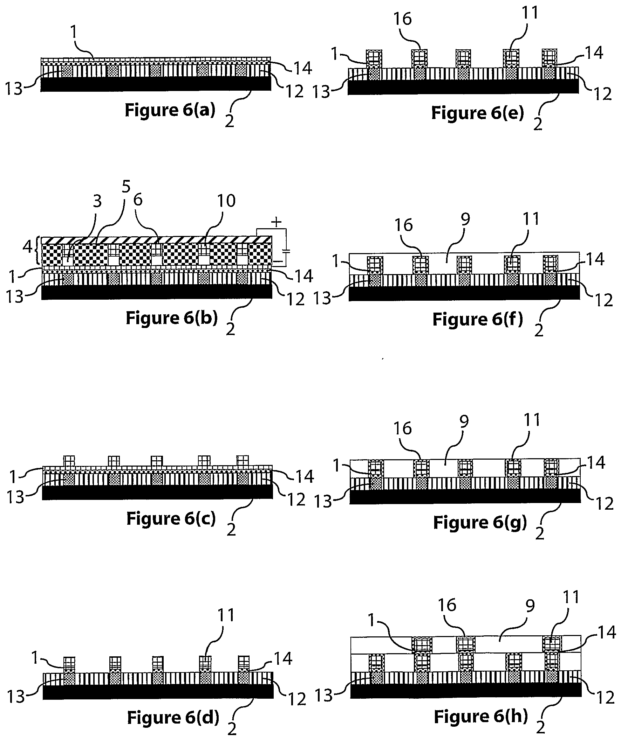

Figures 6 (a) to 6 (n) illustrate the steps for producing a substrate comprising multiple layers of ECPR plated structures including barrier/capping layers and multiple layers of planarized dielectric material.

Figure 6 (a) illustrates a substrate 2 with a patterned pre-metal dielectric layer 12 and connection plugs 13, onto which a barrier/capping layer 14 and a seed layer 1 has been applied using the method in said step "(a)". The substrate is similar to the substrate shown in Fig. 5 (a).

Figure 6 (b) illustrates how a master electrode 4 is aligned to the top layer on the substrate and put in contact with the seed layer 1 and enclosing electrolyte 3 in the cavities of the insulating pattern layer 5 using the method in said step "(b)". When applying a voltage, the predeposited anode material 10 is dissolved at the conducting electrode layer 6 and ECPR plated structures are deposited on the seed layer 1 in the cavities that are filled with electrolyte 3, as described in the method in said step "(c)".

Figure 6 (c) illustrates how ECPR plated structures 11 is formed as a replica (positive image) of the cavities of the master electrode that is separated from the substrate using the method in said step"(d)".

Figure 6 (d) illustrates how the seed layer 1 and the barrier/capping layer 14 are removed between the ECPR plated structures 11. An anisotropic etching method can be used in order to avoid or reduce the etching of the sidewalls and/or undercutting of the ECPR plated structures 11. The seed layer and/or the barrier/capping layer can be of a material that can be selectively etched in respect to the material of the ECPR plated structures 11.

Figure 6 (e) illustrates how a barrier/capping coating 16 selectively is applied and is covering the ECPR plated structures 11. The barrier/capping coating 16 can also form an etch-stop coating as described below.

Figure 6 (f) illustrates how a dielectric material 9 is applied and planarized. The planarization is performed by a polishing action until the dielectric layer is slightly above the structure below as shown in Figure 6(f). This planarization is performed on a single material, namely the soft material of the dielectric layer.

Figure 6 (g) illustrates a final removal of dielectric material until the top of the structure below is uncovered. The final removal can be performed by etching with a method that removes the material with a uniform rate. If the coating 16 has etch-stop properties, the etching only affects the dielectric material. The material is removed until the structure material 8 below is uncovered. The removal can continue for some time to form a safety margin, for example remove 5 to 10% extra material of the dielectric material, calculated from the start of the etch process. If necessary, the barrier/capping coating 16 can be selectively removed from the top of the exposed structure, especially if the coating 16 is an etch-stop coating.

Figure 6 (h) illustrates how a second layer of ECPR plated structures 11 is formed using the methods in said steps "(b)" to "(d)" ; and how the seed layer 1 and the barrier/capping layer 14 is removed between the second ECPR plated structures using the method in said step "(e)"; and how a barrier/capping coating 16 selectively is applied and is covering the ECPR plated structures; and how a second layer of dielectric material 9 is applied and planarized using the method in said step "(f)" uncovering the top of the ECPR plated structures as described above.

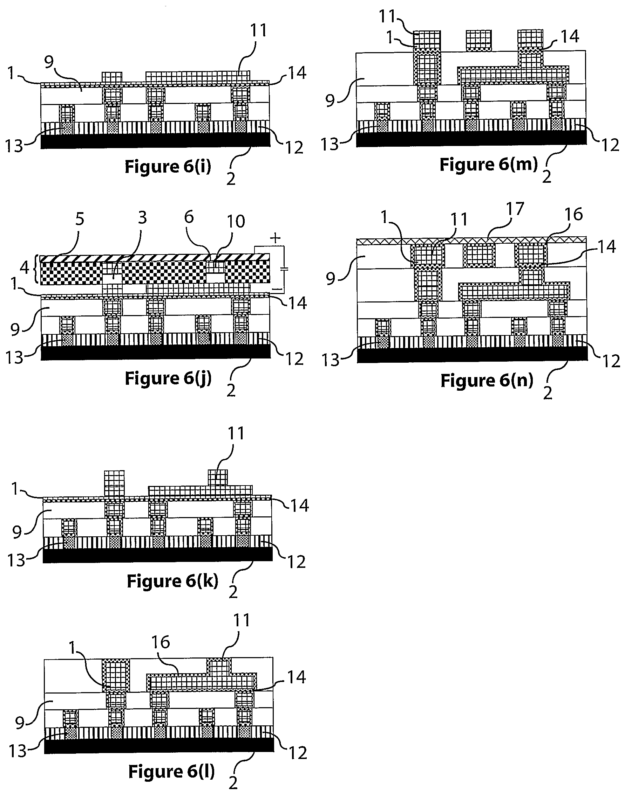

Figure 6(i) illustrates how a barrier/capping layer 14 and a seed layer 1 are applied using the method in said step "(a)"; and how a subsequent layer of ECPR plated structures 11 is formed onto the seed layer using the methods in said steps "(b)" to "(d)".

Figure 6 (j) illustrates how a subsequent layer of ECPR plated structures is formed, using the methods in said steps "(a)" to "(d)", directly onto at least some parts of the previous plated structures without removing the previously applied barrier/capping layer 14 and seed layer 1. The figure illustrates how the master electrode 4 is aligned and put in contact with the previously formed ECPR plated structures using the method in said step "(b)". When a voltage is applied over the master electrode and the seed layer, the predeposited anode material 10 is dissolved and transported in the electrolyte 3 inside the cavities of the insulating pattern layer 5 and a subsequent layer of ECPR plated structures is formed, onto at least some parts of the previous layer of ECPR plated structures.

Figure 6 (k) illustrates how a subsequent layer of ECPR plated structures 11 is formed, with the method in said steps "(a)" to "(d)", onto at least some parts of the preceding layer of ECPR plated structures without removing the preceding barrier/capping layer 14 and seed layer 1.

Figure 6 (I) illustrates how the seed layer 1 and the barrier/capping layer 14 are removed selectively between the ECPR plated structures using the method in said step "(e)" ; how a barrier/capping coating selectively is applied to and is covering both the previous and the subsequent layer the ECPR plated structures 11 and how another layer of dielectric material 9 is applied and planarized to uncover the top of the previous layer of ECPR plated structures, using the method in said step "(f)".

Figure 6 (m) illustrates how a barrier/capping layer 14 and a seed layer 1 is applied using the method in said step "(a)" ; a subsequent layer of ECPR plated structures 11 is formed onto the seed layer 1 using the methods in said steps "(b)" to "(d)" ; and how the barrier/capping layer 14 and seed layer 1 are removed selectively between the ECPR plated structures using the method in said step "(e)".

Figure 6 (n) illustrates how a barrier/capping coating 16 selectively is applied to and is covering the ECPR plated structures 11 and how another layer of dielectric material 9 is applied and planarized using the method in said step "(f)". Finally, a passivation layer 17 is applied to cover the dielectric material and the top of the ECPR plated structures, which are covered with a barrier/capping coating. In some embodiments, forming multiple metallic interconnect layers and dielectric layers in a semiconductor device includes creating at least one layer of ECPR plated structures and dielectric material, as illustrated in Fig. 5 and Fig 6, using either etching or plating or a combination thereof, and creating at least another layer of conducting structures and dielectric material using known lithographical and plating techniques such as the dual damascene or single damascene process.

Some embodiments, such as when forming metallic interconnects for integrated circuits (IC), includes fabricating said interconnects by forming multiple ECPR plated structure layers, for instance comprising Cu, and arranging a dielectric material, such as a low-k material, between said structures. In said known damascene process, the dielectrics layers are firstly etched and subsequently interconnects are electroplated filling the cavities etched. In order to decrease the RC-delay of an IC device, dielectric materials with lower dielectric constant is required. However, with ultra low-k dielectric material, etching and post-etch- cleaning may result in various problems such as too high line width variations and k-value increase. As described above, the method of the present process can eliminate or reduce the number of etching steps of said layers of dielectric material, for instance ultra low-k dielectric layers. Said elimination or reduction of number of etching steps results in less line width variations and less k-value increase which enables the use of ultra low-k materials in an IC device and hence a lower RC-delay as well as less RC-delay variations can be achieved.

ECPR plating can be used to fill vias or other grooves in a substrate and/or in a patterned material onto a substrate.

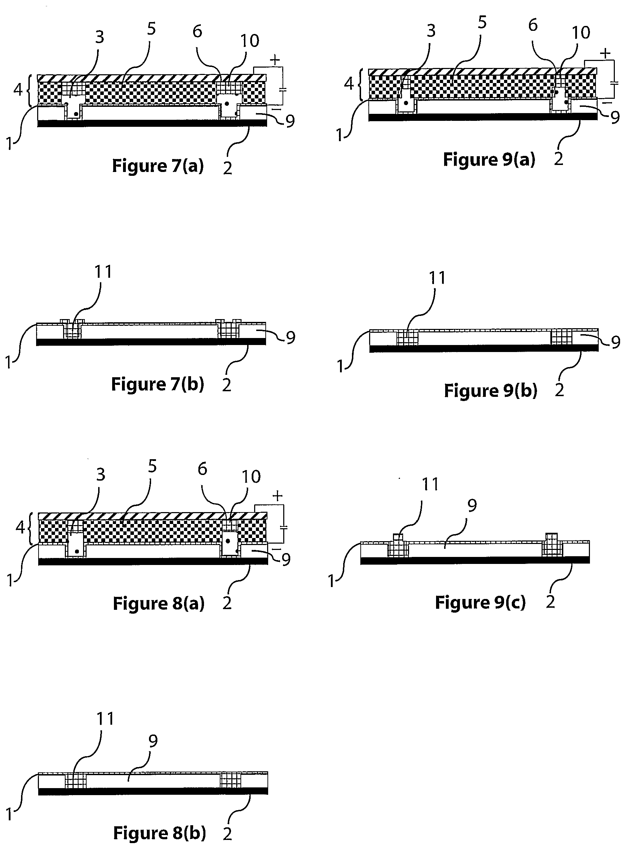

Fig 7 (a) illustrates a via-substrate comprising a substrate 2, a patterned dielectric material 9 and a seed layer 1. A master electrode is aligned and put in contact with the seed layer, using the methods in said step "(b)", in such a way that the walls of the insulating pattern layer 5 which define the cavities of the master electrode 4 are placed outside of the lateral extent of the vias in the dielectric material 9, the cavities of the master electrode having a larger width than the vias. The predeposited anode material 10 is transferred in the electrolyte 3 by ECPR plating using the method in said step " (c)".

Figure 7 (b) illustrates how the cavities of the dielectric material 9 are filled with ECPR plated structures 11. The material deposited on top of the seed layer beside the via can include a groove as shown in Figure 7 (b). However, the groove is in some cases of no or less importance. By using certain chemicals in the electrolyte, the formation of such a groove can be completely or partly eliminated. Such chemicals can include additive systems such as described above. Moreover, the grooves can be reduced by using pulse plating methods such as pulse reverse plating.

Figures 8 (a) to 8 (b) illustrate the steps for filling the vias of a substrate with a patterned dielectric material when aligning the cavities of the master electrode edge to edge with the via-holes, the cavities of the master electrode having the same width as the via-holes.

Figure 8 (a) illustrates how the master electrode is aligned and put in contact with the seed layer, using the methods in said step "(b)", in such way that the walls of the insulating pattern layer 5 which define the cavities of the master electrode 4 are placed "edge to edge" of the walls of the vias in the dielectric material 9. The predeposited anode material 10 is transferred in the electrolyte 3 by ECPR plating using the method in said step "(c)".

Figure 8 (b) illustrates how the cavities of the dielectric material 9 are filled with ECPR plated structures 11.

Figures 9 (a) to 9 (c) illustrate the steps for filling the vias of a substrate with a patterned dielectric material when aligning the cavities of the master electrode within the lateral extent of the via-holes, the cavities of the master electrode having a smaller width than the via-holes.

Figure 9 (a) illustrates how the master electrode is aligned and put in contact with the seed layer, using the method in said step "(b)", in such way that the walls of the insulating pattern layer 5 which define the cavities of the master electrode 4 are placed within the lateral extent of the vias in the dielectric material 9. The predeposited anode material 10 is transferred in the electrolyte 3 by ECPR plating using the method in said step " (c)", as shown in Figure 9 (a).

Figure 9 (b) illustrates how the cavities of the dielectric material 9 are filled with ECPR plated structures 11.

Figure 9(c) illustrates how the ECPR plated structures 11 are formed above the dielectric material layer as a replica (positive image) of the cavities of insulating pattern layer on the master electrode.

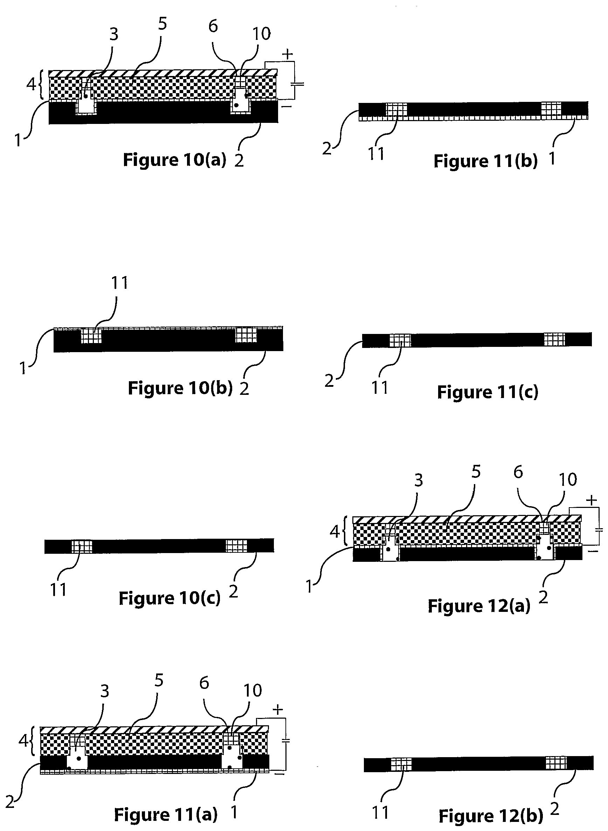

Figures 10 (a) to 10 (c) illustrate the steps for forming a filled through-hole-substrate by filling a via-hole-substrate and planarizing the backside.

Figure 10 (a) illustrates how a master electrode 4 is aligned and put in contact with a seed layer 1 on a substrate 2 patterned with via-hole cavities. The walls of the cavities of the insulating pattern layer 5 can be placed within or outside the lateral extent of, or edge to edge with the walls of the cavities of the substrate. When a voltage is applied, predeposited anode material 10 is dissolved at the conducting electrode layer 6 and ECPR plated structures are formed onto the seed layer 1 in the cavities that comprise the electrolyte 3.

Figure 10 (b) illustrates how the cavities of the substrate 2 are filled with ECPR plated structures 11.

Figure 10 (c) illustrates how the seed layer on the front side is removed, the backside of the substrate 2 has been planarized and how the bottom of the ECPR plated structures 11 is uncovered by etching, planarization and/or grinding from the backside.

Figures 11 (a) to 11 (c) illustrate the steps for forming a filled through-hole-substrate by filling a through-hole- substrate with a seed layer on the backside.

Figure 11 (a) illustrates how a master electrode 4 is aligned and put in contact with the front side of a substrate 2 patterned with through-hole cavities and a seed layer 1 on the backside. The walls of the cavities of the insulating pattern layer 5 can be placed within (as illustrated in this figure), or outside the lateral extent of, or edge to edge with the walls of the cavities of the substrate. When a voltage is applied, predeposited anode material 10 is dissolved at the conducting electrode layer 6 and ECPR plated structures are formed onto the seed layer 1 in the cavities that comprise the electrolyte 3. Figure 11 (b) illustrates how the cavities of the substrate 2 are filled with ECPR plated structures 11.

Figure 11 (c) illustrates how the seed layer on the backside is removed and how the bottom of the ECPR plated structures 11 is uncovered.

Figures 12 (a) to 12 (b) illustrate the steps for forming a filled through-hole-substrate by filling a through-hole- substrate onto which a seed layer has been applied.

Figure 12 (a) illustrates how a master electrode 4 has been aligned and put in contact with a seed layer 1 on a substrate 2 patterned with via-through-hole cavities whereby the seed layer 1 extends on the front-side and on the walls of the via-through-holes. The walls of the cavities of the insulating pattern layer 5 can be placed within (as illustrated in this figure), or outside the lateral extent of, or edge to edge with the walls of the cavities of the substrate. When a voltage is applied, predeposited anode material 10 is dissolved at the conducting electrode layer 6 and ECPR plated structures are formed onto the seed layer 1 in the cavities that comprise the electrolyte 3.

Figure 12 (b) illustrates how the cavities of the substrate 2 are filled with ECPR plated structures 11 and how the seed layer is removed on the front side.

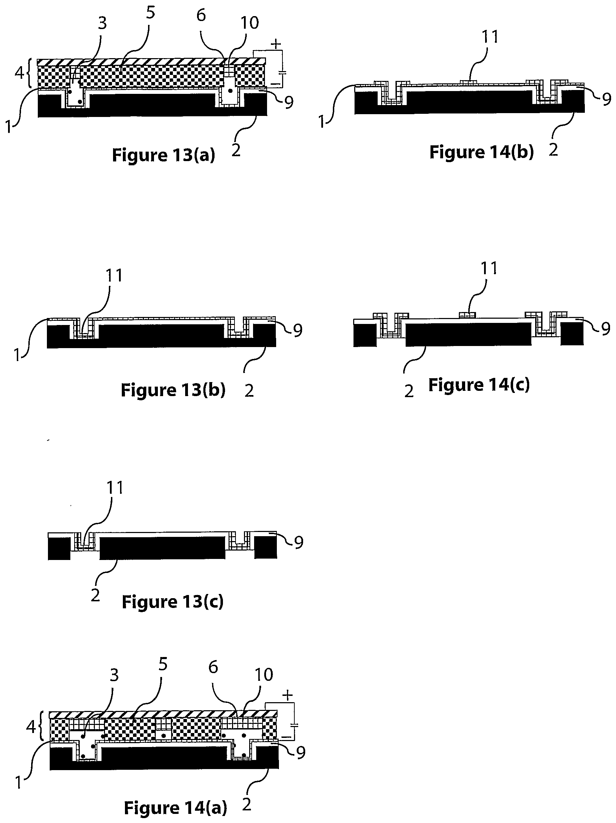

Figures 13 (a) to 13 (c) illustrate the steps for forming a filled through-hole-substrate including filling a via-hole- substrate that is coated with a dielectric material and including patterning the substrate backside.

Figure 13 (a) illustrates how a master electrode 4 has been aligned and put in contact with a seed layer 1 on a substrate 2 patterned with via-hole cavities, which in turn have been patterned by a dielectric material 9 which covers the substrate front-side and the vertical walls of the vias. The walls of the cavities of the insulating pattern layer 5 can be placed within (as illustrated in this figure), or outside the lateral extent of, or edge to edge with the walls of the cavities of the substrate. When a voltage is applied, predeposited anode material 10 is dissolved at the conducting electrode layer 6 and ECPR plated structures are formed onto the seed layer 1 in the cavities that comprise the electrolyte 3.

Figure 13 (b) illustrates how the cavities of the substrate 2, which are coated with a patterned dielectric material 9, are partly filled with ECPR plated structures 11.

Figure 13 (c) illustrates how the seed layer on the front side is removed and how the backside of the substrate 2 is patterned to uncover the bottom of the ECPR plated structures 11 and the dielectric material 9.

Figures 14 (a) to 14 (c) illustrate the steps for forming a filled and front side patterned through-hole-substrate.

Figure 14 (a) illustrates how a master electrode 4 is aligned and put in contact with a seed layer 1 on a substrate 2 patterned with via-hole cavities, which in turn have been patterned by a dielectric material 9. The walls of the cavities of the insulating pattern layer 5 can be placed within or outside (as illustrated in this figure) the lateral extent of, or edge to edge with the walls of the cavities of the substrate. Some parts of the cavities of the insulating pattern layer 5 can be located in areas, separate from the substrate cavities, where ECPR plated structures also are to be formed. When a voltage is applied, predeposited anode material 10 is dissolved at the conducting electrode layer 6 and ECPR plated structures are formed onto the seed layer 1 in the cavities that comprise the electrolyte 3.

Figure 14 (b) illustrates how the cavities of the substrate 2, which are coated with a patterned dielectric material 9, are filled and how ECPR plated structures 11 also are formed on some parts of the seed layer 1.

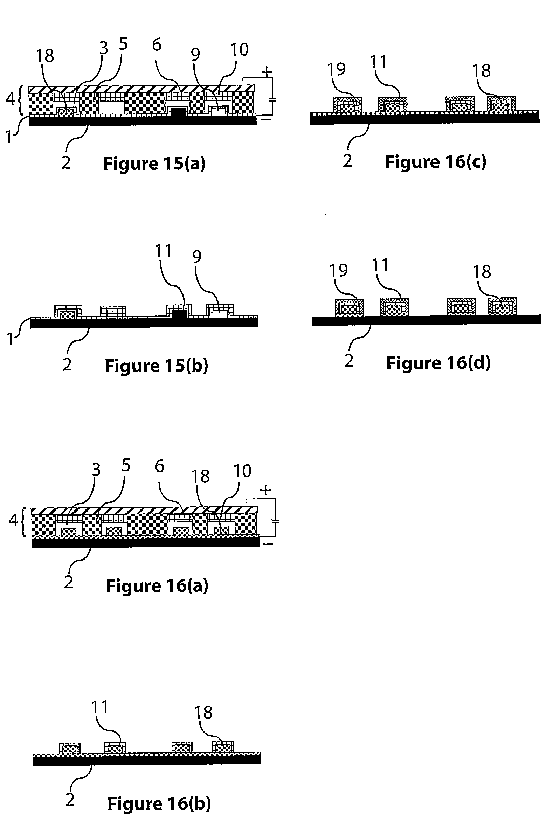

Figure 14 (c) illustrates how the seed layer on the front side is removed in the areas between the ECPR plated structures 11 and how the backside of the substrate 2 is patterned to uncover the bottom of the ECPR plated structures. Figures 15 (a) to 15 (c) illustrate the steps for coating a patterned substrate, which is covered with a seed layer, with ECPR plated structures. Figure 15 (a) illustrates how a master electrode 4 has been aligned and put in contact with a seed layer 1 on a substrate 2 patterned with structures. The structures exerting the pattern on the substrate can for instance be a conducing pattern 18, a substrate pattern and/or a dielectric material pattern 9. The master electrode can be placed in a way that the cavities of the insulating pattern layer 5 enclose at least some parts of the substrate structures. Some parts of the cavities of the insulating pattern layer 5 can be located in areas, separate from the substrate structures, where ECPR plated structures also are to be formed. When a voltage is applied, predeposited anode material 10 is dissolved at the conducting electrode layer 6 and ECPR plated structures are formed onto the seed layer 1 in the cavities that comprise the electrolyte 3.

Figure 15 (b) illustrates how the substrate structures that were enclosed in the cavities of insulating pattern layer of the master electrode are coated with ECPR plated structures 11. Also, other areas corresponding to the cavities of the insulating pattern layer of the master electrode that do not enclose the substrate structures, are patterned with ECPR plated structures.

Figures 16 (a) to 16 (d) illustrate the steps for creating multiple coating layers on a substrate patterned with conducting material.

Figure 16 (a) illustrates how a master electrode 4 is aligned and put in contact with a seed layer onto which conducting material structures are formed 18. The master electrode can be placed in a way that the cavities of the insulating pattern layer 5 enclose at least some parts of the conducting material structures 18. When a voltage is applied, predeposited anode material 10 is dissolved at the conducting electrode layer 6 and ECPR plated structures are formed onto the seed layer and the conducting material structures 18 in the cavities that comprise the electrolyte 3. Figure 16 (b) illustrates how the conducting material structures 18 that are enclosed in the cavities of the master electrode are coated with ECPR plated structures 11.

Figure 16 (c) illustrates how a second coating of ECPR plated structures 11 is applied to the previously coated material 19 covering the conducting material structures 18.

Figure 16 (d) illustrates how the seed layer selectively is removed in the areas between the coated structures. This method can be repeated one or several times whereby one or several layers of ECPR plated structures 11 can be coated onto the previously coated material 19 on the conducing material 18 structures. The different layers of ECPR plated structures can be of the same or several different materials. The conducting material 18 can be Cu, the first coated material 19 can be Ni and the second coating of ECPR plated structures 11 can be Au. The conducing material 18 can be Cu, the first coated material 19 can be Sn and the second coating of ECPR plated structures 11 can be Ag. The ECPR plated structures that coat the substrate pattern comprises a barrier/capping material, adhesion material, etch-mask material and/or etch- stop material.

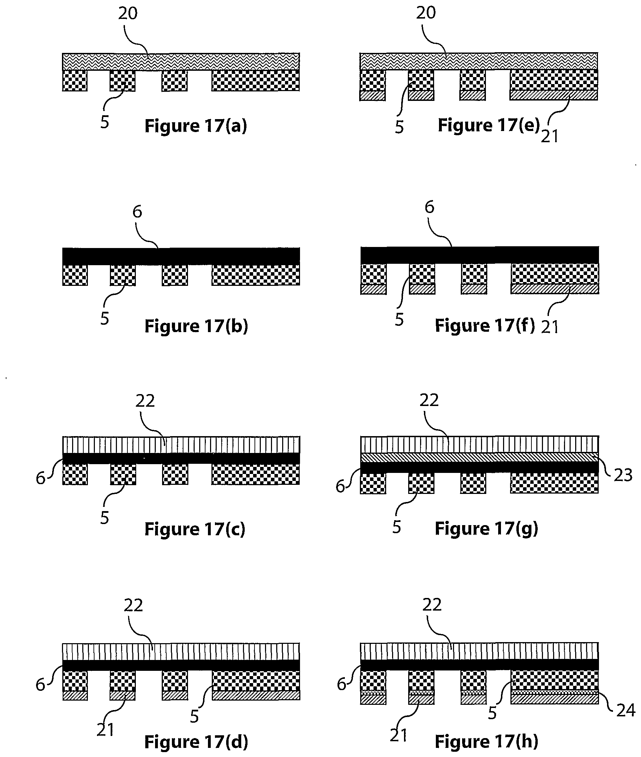

Figures 17 (a) to 17 (h) are sectional views of different exemplary combinations of designs and materials of a master electrode.

Figure 17 (a) illustrates a sectional view of a master electrode comprising a flexible conducting foil 20 and an insulating pattern layer 5.

Figure 17 (b) illustrates a sectional view of a master electrode comprising a conducting electrode layer 6 and an insulating pattern layer 5.

Figure 17 (c) illustrates a sectional view of a master electrode comprising a mechanical support layer 22, a conducting electrode layer 6 and an insulating pattern layer 5.

Figure 17 (d) illustrates a sectional view if a master electrode comprising a mechanical support layer 22, a conducting electrode layer 6, an insulating pattern layer 5 and a flexible elastomer layer 21.

Figure 17 (e) illustrates a sectional view of a master electrode comprising a flexible conducting foil 20, an insulating pattern layer 5 and a flexible elastomer layer 21.

Figure 17 (f) illustrates a sectional view of a master electrode comprising a conducting electrode layer 6 an insulating pattern layer 5 and a flexible elastomer layer 21.

Figure 17 (g) illustrates a sectional view of a master electrode comprising a mechanical support layer 22, a conducting elastomer layer 23, a conducting electrode layer 6 and an insulating pattern layer 5.

Figure 17 (h) illustrates a sectional view of a master electrode comprising a mechanical support layer 22, a conducting electrode layer 6, an insulating pattern layer 5 and intermediate metal layer 24 and a flexible elastomer layer 21.

The master electrode comprises at least one insulating pattern layer and at least one conducting electrode layer (normally inert in the ECPR process) and possibly a predeposited anode material in the cavities of the master electrode. For instance, the insulting pattern of the master layer is a polymer, e.g. a photoresist, an oxide, e.g. SiO₂, a nitride, e.g. SiN, or combinations thereof. The electrolyte comprises suitable substances for dissolving and depositing the conducting material in which the structures are formed during the ECPR process. For instance, when the conducting material is copper, the electrolyte comprises an aqueous solution of Cu²⁺, SO₄²⁻, H⁺ and/or Cl⁻ and additives such as levelers, accelerators, brighteners, suppressors and wetting agents. Appropriate additives can be poly-ethyleneglycol (PEG), chloride ions, MPSA, SPS and/or sodium-lauryl-sulfate.

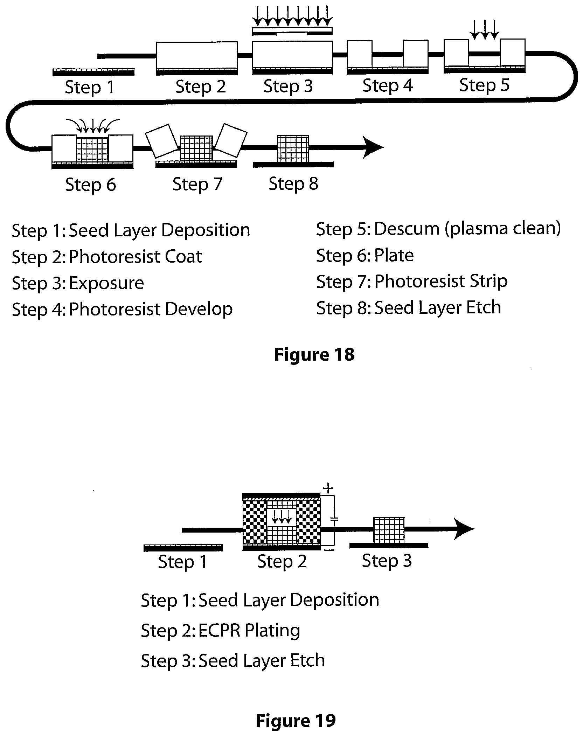

Figure 18 illustrates the schematic eight step process of conventional lithography and electroplating.

Figure 19 illustrates the schematic three step process of producing a plating pattern with the ECPR method.

An etching pattern is created with an electrochemical process by using the conducting electrode layer of the master electrode as cathode whereby material is dissolved from the substrate, transferred in the electrolyte and deposited on the cathode thereby creating ECPR etched structures on the substrate corresponding to the pattern of insulating pattern layer on the master electrode. Since the material that is being dissolved from the substrate, which is anode, also is deposited at the conducting electrode layer, which is cathode, the amount of dissolved anode material in the electrolyte remains close to constant during the electrochemical process. If the deposition rate of the dissolved material is zero, the concentration of dissolved anode material ions in the electrolyte increases quickly, this slows down the electrochemical reaction until it eventually stops. A too high ion concentration can also result in precipitation of salts. In this case, only small amounts could be dissolved from the substrate and only thin layers could be patterned. Instead, by making sure that the dissolution reaction has an appropriate deposition reaction, substrates with thicker layers can be etched. The dissolution and deposition reaction in the electrochemical process is determined by the thermodynamic and kinetic reaction at a given applied potential in a specific system of anode, cathode and electrolyte. By choosing the appropriate anode material, cathode material and electrolyte, the desired dissolution and deposition reaction can be achieved since they are thermodynamically and kinetically favorable in the chosen system.

One example of appropriate anode, cathode and electrolyte system is Ni as anode material, Au as a cathode material and a Watt's bath used as electrolyte. In some aspects, the deposition reaction does not have to be corresponding to the dissolution reaction exactly. As long as the deposition rate of the dissolved material is larger than zero, the buildup of ion concentration of anode material in the electrolyte will be slow which means that it will take longer time before the reaction stops and hence thicker layers on the substrate can be etched. For instance, the deposition rate of the dissolved ions can be 90-100% of the dissolution rate. In this example, the ion concentration of dissolved anode will increase slowly, but in some aspects a desired etched thickness can be achieved before the concentration becomes too high. In some cases, the dissolution rate can be lower than the deposition speed, which eventually leads to depletion of ion concentration in the electrolyte. However, if the dissolution reaction is not too low compared to the deposition reaction (e.g. >90% of the deposition rate), a desired thickness can still be etched from the substrate before depletion of anode material ions in the electrolyte. One example of an inappropriate system is Ag as anode material, Al as cathode material and an alkaline silver cyanide bath as an electrolyte. In this example, the deposition rate of silver ions is zero, which will lead to a fast buildup of silver ions in the electrolyte.

A plating pattern is created by an electrochemical process by using the conducting electrode layer of the master electrode as anode and having predeposited anode material on the anode inside the cavities defined by the master electrode whereby said anode material is dissolved, transferred in the electrolyte and deposited on the substrate, being cathode, thereby creating ECPR plated structures on the substrate corresponding to the cavities of the insulating pattern layer on the master electrode.

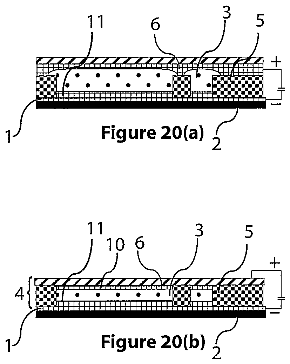

One problem with prior art processes which do not have a predeposited material is that anode material is dissolved directly from conducting electrode layer 6 in the master 4, the master electrode will eventually wear out since the dissolved material is undercutting the insulating pattern layer 5, as illustrated in Figure 20 (a). By having a predeposited anode material 10 in the cavities of the master electrode 4, it is possible the have a conducting electrode layer 5 comprising an inert material that does not dissolve during the electrochemical process and no undercutting of the insulating pattern layer 5 occurs, as illustrated in Figure 20 (b). Thereby, the master electrode can be reused a large number of times, which leads to a more cost and time efficient patterning process.

Another problem with prior art processes, which do not have predeposited material is that the dissolved material that is undercutting the insulating pattern layer leads to that the anode area increases differently in large contra small cavities in the insulating pattern layer. In large cavities, the area increase due to undercutting is smaller than in small cavities, as illustrated in Figure 20 (a) . Increasing the anode area leads to a higher current density (i.e. plating rate) at the cathode. Hence, the structures plated in the small cavities of the insulating pattern layer will be deposited with a higher plating rate than the structures in the large cavities leading to an uneven thickness distribution that depends on the pattern. Also this problem is solved by having a predeposited material, since no area increase will occur and thereby the current density (plating rate) will be the same in all cavities, non-depending on the size of the patterns. Also, the dissolution of predeposited material prevents the depletion of the concentration of ions in the electrolyte that are deposited on the cathode. A depletion of ions in the electrolyte would gradually slow down the deposition process until it eventually stops and only thin layers of plated structures would be achievable. By having a sufficient amount of predeposited material that is being dissolved during the electrochemical deposition reaction, the ion concentration remains stable and thicker layers of plated structures can be achieved. By choosing the appropriate predeposited material (anode), seed layer material (cathode) and electrolyte, the desired dissolution and deposition reaction can be achieved since they are thermodynamically and kinetically favorable in the chosen system. One example of an appropriate choice of electrochemical system is: having Cu as predeposited material (anode), Cu as seed layer (cathode) and an acidic copper sulfate bath as an electrolyte. In some cases, the deposition reaction does not have to be corresponding to the dissolution reaction exactly. As long as the dissolution rate of the predeposited material is larger than zero, the depletion of ion concentration in the electrolyte will be slower which means that it will take longer time before the reaction stops and hence thicker layers can be plated. For instance, the dissolution rate can be 90-100% of the deposition rate. In this example, the ion concentration of material being deposited will decrease slowly, but in some aspects a desired plated thickness can be achieved before the concentration becomes too low.

As mentioned above, the method may include applying a barrier/capping coating 16 onto the top layer on the substrate 2 prior to applying a dielectric material 9. This may be done with a mask-less method, as mentioned in said step "(f)", selectively coating the ECPR plated structures 11. In some embodiments, it can be suitable not to remove the barrier/capping layer 14 after removing the seed layer 1 and prior to applying the barrier/capping coating 16. In this way, top layer on the substrate 2, for instance a dielectric material layer, is protected by the barrier/capping layer 14 in the following step of applying the barrier/capping coating 16. The barrier/capping layer 14 can be of a material onto which no barrier/capping coating 16 is deposited during the mask-less method used for applying the coating onto the ECPR plated structures 11. After applying the barrier/capping coating selectively onto the ECPR plated structures 11, the barrier/capping layer 14 between the structures can be removed using said removing methods for the layer described in said step "(e)". The barrier/capping material may comprise a material that can be etched with a dry-etch method described in said step " (e)". The barrier/capping coating 16 may comprise a material that is not affected by the removing method used for the barrier/capping layer 14 or at least less affected than the material used for the barrier/capping layer 14.

The height of the different material layers is indicated in the drawings to be of the same size. However, each individual layer can be of any dimension as required by the construction. However, normally, each layer is of a uniform height over the entire surface of the substrate, i.e. the layer has a substantially constant thickness.

## Claims

1. Method of forming a multilayer structure by electroplating on a substrate (2), comprising the steps of:
a) arranging an electrically conducting seed layer (1) on at least a part of the substrate (2) or a substrate layer (2);
b) applying a master electrode (4) on said seed layer (1), said master electrode (4) having an electrically conducting electrode layer (6), an insulating pattern layer (5) and predeposited anode material (10) arranged onto said conducting electrode layer (6) in the cavities of said insulating pattern layer (5), for forming at least one electrochemical cell comprising an electrolyte (3) in the area enclosed by said anode material (10), said insulating pattern layer (5) and said seed layer (1); wherein said anode material (10) is being in electrical contact with said conducting electrode layer (6);
c) applying a voltage between said conducting electrode layer (6) and said seed layer (1) so that said seed layer (1) forms a cathode for transferring at least some of said anode material (10) in said at least one cell to said seed layer (1) for forming plated structures (11) corresponding to the cavities of the insulating pattern layer (5) on the master electrode (4);
d) separating said master electrode (4) from said substrate (2);
e) removing said seed layer (1) in non-plated areas;
f) arranging a dielectric material (9) by spin-coating in the areas in between the plated structures (11) for forming a material layer (9) that at least partly covers said plated structures (11);
g) planarization of the material layer (9), until at least part of the structures (11) is uncovered;
h) repeating at least some of said steps for providing a multilayer structure.

2. The method of claim 1, wherein said step of planarization further comprises removing further material (9) by a removal method having substantially uniform removal rate over the entire surface until at least a part of the structures (11) is uncovered.

3. The method of claim 1, further comprising:
between the steps d) and e)
applying a further master electrode (4) for forming electrochemical cells with the structures (11) previously formed; and
applying a voltage for forming a further layer of plated structures (11) on top of the previously formed layer of structures (11).

4. The method of claims 1 to3, wherein said step of planarization is performed by at least one polishing step selected from the group comprising: mechanical-polishing, chemical-polishing, chemical-mechanical-polishing (CMP), contact planarization (CP), planarization with a doctor blade, and combinations thereof, and/or etching step selected from the group comprising: dry-etching methods, ion-sputtering, reactive-ion-etching (RIE), plasma-assisted-etching, laser-ablation, ion-milling, and combinations thereof.

5. A method of forming a multilayer structure by electroplating on a substrate (2), comprising:
a) arranging an electrically conducting seed layer (1) on at least a part of the substrate (2) or a substrate layer (2);
b) applying a master electrode (4) on said seed layer (1), said master electrode (4) having an electrically conducting electrode layer (6), an insulating pattern layer (5) and predeposited anode material (10) arranged onto said conducting electrode layer (6) in the cavities of said insulating pattern layer (5) for forming at least one electrochemical cell comprising an electrolyte (3) in the area enclosed by said anode material (10), said insulating pattern layer (5) and said seed layer (1); wherein said anode material (10) is being in electrical contact with said conducting electrode layer (6);
c) applying a voltage between said conducting electrode layer (6) and said seed layer (1) so that said seed layer (1) forms a cathode for transferring at least some of said anode material (10) in said at least one cell to said seed layer (1) for forming plated structures (11) corresponding to the cavities of the insulating pattern layer (5) on the master electrode (4);
d) separating said master electrode (4) from said substrate (2);
e) removing said seed layer (1) in non-plated areas;
f) arranging a dielectric material (9) by spin-coating in the areas in between the plated structures for forming a material layer (9) that covers said plated structures (11);
i) providing recesses in said material layer (9) for uncovering at least a part of the plated structure (11) there below;
h) repeating at least some of said steps for providing a multilayer structure.

6. The method of claim 5, wherein said step of providing recesses in said material layer (9) is performed by a lithographic method selected from the group comprising: photolithography, laser lithography, E-beam lithography, nanoimprinting and combinations thereof.

7. The method of claim 6, wherein said lithographic method further comprises patterning an etch-mask (15) and etching said material layer (9) with dry-etching methods, such as ion- sputtering, reactive-ion-etching, plasma-assisted-etching, laser-ablation, ion-milling or combinations thereof.

8. The method of claim 7, wherein said etch-mask (15) is dry-etched using a resist, such as a photoresist, as a mask (15); whereas said resist has been patterned with said lithographic method.

9. The method of claim 5, wherein said material layer (9) is planarized before providing recesses.

10. The method of claim 5, further comprising applying a barrier/capping layer (14) before step a) or step f).

11. The method of any of the previous claims, wherein said planarization step comprises performing a polishing step until said material surface is substantially planar and a subsequent etching step of said material surface until at least part of said structures (11) is uncovered.

12. The method of any of the previous claims, wherein a planarizing material is applied onto said material layer (9) prior to performing said planarization step of said material layer (9).

13. The method of claim 12 wherein said planarizing material is applied with a method selected from the group comprising: spin-coating, spray-coating, powder-coating, dip- coating, roller-coating, sputtering, PVD, CVD, PECVD, electrodeposition, and combinations thereof.

14. The method of any of the previous claims, wherein an end-point detection method is used so as to determine when said planarization step is completed.

15. The method of any one of the previous claims, wherein the step of contact planarization comprises: applying a plate above said material layer (9) and applying a pressure on said plate for equalizing the material (9) in said material layer (9), while in a flowable condition.

16. The method of claim 15, wherein said flowable condition is obtained by heating said material layer, whereupon the material is cooled after planarization.

17. The method of claim 16, wherein said step of applying the plate is performed before curing said material, whereupon the material is cured after planarization, such as by applying infrared or ultraviolet radiation.

18. The method of claim 1or 5, wherein the seed layer (1) is made of material selected from the group comprising: Ru, Os, Hf, Re, Cr, Au , Ag, Cu, Sn, Ti, TiN, TiW, Ni, NiB, NiP, NiCo, NiBW, NiM-P, Al, Pd, Pt, W, Ta, TaN, Rh, Wo, Co, CoReP, CoP, CoWP, CoWB, CoWBP alloys of these material, Si, conducting polymers such as polyaniline; solder materials, such as SnPb, SnAg, SnAgCu, SnCu, alloys, sucha as monel and permalloy; and alloys thereof and combinations thereof.

19. The method of claim 18, wherein the seed layer (1) is applied by a method selected from the group comprising: chemical-vapor-deposition (CVD), metallorganic- chemical-vapor-deposition (MOCVD), physical -vapor-deposition (PVD), atomic layer deposition (ALD), sputtering, electroless plating, electroplating, electro-grafting, immersion deposition, and combinations thereof.

20. The method of claim 10, wherein said barrier/capping material comprises at least one layer of material that prevents corrosion, diffusion or electromigration of layers which are interfacing with said barrier/capping material.

21. The method of claim 10, wherein said barrier/capping material is applied by a method selected from the group comprising: electrodeposition, MOCVD, CVD, PVD, ALD, sputtering, electroless deposition, immersion deposition, electrografting and combinations thereof.

22. The method of claim 21, wherein said barrier/capping material is applied with a mask-less selective deposition method, such as electroless deposition, wherein deposition is obtained only in surfaces active to said deposition process, such as on said structure layer (11) and not on said arranged material layer (9).

23. The method of claim 10, wherein said barrier/capping material is used as a seed layer (1) in said step a).

24. The method of claim 10, further comprising applying an adhesion layer before applying said seed layer (1) and/or before applying said barrier/capping material; wherein said adhesion layer increase the adhesion of said seed layer (1) or barrier/capping layer (14) to said arranged material layer (9) or structures (11).

25. The method of any of the previous claims, wherein said forming of at least one electrochemical cell comprises a method for aligning said insulating pattern layer (5) to a patterned layer on said substrate (2), wherein said aligning method comprises using alignment marks on the front side and/or back side of said master electrode (4) which are aligned to corresponding alignment marks on said substrate (2).

26. The method of any of the previous claims, wherein said formed electrochemical cell comprises a solution of cations, such as copper or nickel ions, and anions, such as sulfate ions, for electrochemical etching and/or plating.

27. The method of claim26, wherein said electrolyte (3) comprises suppressors, levelers and/or accelerators, for instance PEG (poly-ethylene glycol) together with chloride ions and/or with SPS (bis- (3 -sulfopropyl) -disulfide), MPSA and/or sodium-lauryl-sulphate.

28. The method of any of the previous claims, wherein said anode material (10) is arranged onto said conducting electrode layer (6) in the cavities of said insulating pattern layer (5) using a method selected from the group comprising: electroplating, electroless plating, immersion plating, CVD, MOCVD, powder-coating, chemical grafting, electrografting and combinations thereof.

29. The method of any of the previous claims, wherein said separation step d) is performed by holding said substrate (2) in a fixed position and moving said master electrode (4) in a direction perpendicular to the substrate (2) surface; or by holding said master electrode (4) in a fixed position and moving said substrate (2) in a direction perpendicular to the master electrode (4) surface; or by performing the separation in a less parallel manner so as to ease the separation; or by a combination thereof.

30. The method of any of the previous claims, wherein said step e) removing said seed layer (1) is performed by wet- etching, dry-etching, electrochemical etching or by combinations thereof.

31. The method of claim30, further comprising applying a protective coating which is covering all or substantially all of said seed layer (1), barrier/capping layer (14) and/or structure layer (11); treating said protective coating with an anisotropic etch, thereby uncovering the top of said seed layer (1), barrier/capping layer (14) and/or structure layer (11) between the structures (11) while leaving a protective layer on the side walls of said structures (11); removing said seed layer (1) and/or barrier layer (14) between said structures (11).

32. The method of any of the previous claims, further comprising: arranging an etch-stop layer on top of the structures (11) before the step f) of arranging the material (9).

33. The method of any of the previous claims wherein, said material layer (9) is a porous low-k dielectric material (9) and a pore sealing operation is performed prior to applying further layers of material onto it.

## Patentansprüche

1. Verfahren zur Bildung einer Mehrschichtstruktur durch Elektroplattierung auf einem Substrat (2), umfassend folgende Schritte:
a) Anordnen einer elektrisch leitenden Keimschicht (1) auf mindestens einem Teil des Substrats (2) oder einer Substratschicht (2);
b) Anlegen einer Masterelektrode (4) an die Keimschicht (1), wobei die Masterelektrode (4) eine elektrisch leitende Elektrodenschicht (6), eine isolierende Musterschicht (5) und vorab abgeschiedenes Anodenmaterial (10), das auf der leitenden Elektrodenschicht (6) in den Hohlräumen der isolierenden Musterschicht (5) angeordnet ist, aufweist, zur Bildung mindestens einer elektrochemischen Zelle, umfassend einen Elektrolyten (3) in dem von dem Anodenmaterial (10), der isolierenden Musterschicht (5) und der Keimschicht (1) umschlossenen Gebiet; wobei das Anodenmaterial (10) in elektrischem Kontakt mit der leitenden Elektrodenschicht (6) steht;
c) Anlegen einer Spannung zwischen der leitenden Elektrodenschicht (6) und der Keimschicht (1), sodass die Keimschicht (1) eine Kathode bildet, die dazu dient, mindestens etwas von dem Anodenmaterial (10) in der mindestens einen Zelle auf die Keimschicht (1) zu übertragen, um plattierte Strukturen (11) zu bilden, die den Hohlräumen der isolierenden Musterschicht (5) an der Masterelektrode (4) entsprechen;
d) Trennen der Masterelektrode (4) von dem Substrat (2);
e) Entfernen der Keimschicht (1) in nicht plattierten Gebieten;
f) Anordnen eines dielektrischen Materials (9) durch Schleuderbeschichtung in den Gebieten zwischen den plattierten Strukturen (11), um eine Materialschicht (9) zu bilden, welche die plattierten Strukturen (11) mindestens teilweise bedeckt;
g) Planarisierung der Materialschicht (9), bis mindestens ein Teil der Strukturen (11) freigelegt ist;
h) Wiederholen mindestens einiger der besagten Schritte, um eine Mehrschichtstruktur bereitzustellen.

2. Verfahren nach Anspruch 1, wobei der Schritt der Planarisierung weiter das Entfernen weiteren Materials (9) durch ein Entfernungsverfahren, das eine im Wesentlichen gleichförmige Entfernungsrate über die gesamte Oberfläche aufweist, bis mindestens ein Teil der Strukturen (11) freigelegt ist, umfasst.

3. Verfahren nach Anspruch 1, weiter umfassend:
zwischen den Schritten d) und e)
Anbringen einer weiteren Masterelektrode (4) zur Bildung elektrochemischer Zellen mit den zuvor gebildeten Strukturen (11); und
Anlegen einer Spannung zur Bildung einer weiteren Schicht plattierter Strukturen (11) oben auf der zuvor gebildeten Schicht von Strukturen (11).

4. Verfahren nach den Ansprüchen 1 bis 3, wobei der Schritt der Planarisierung vollzogen wird durch mindestens einen Polierschritt, der aus der Gruppe ausgewählt ist, umfassend: mechanisches Polieren, chemisches Polieren, chemisch-mechanisches Polieren (CMP), Kontaktplanarisierung (CP), Planarisierung mit einer Rakel, und Kombinationen davon, und/oder Ätzschritt, ausgewählt aus der Gruppe, umfassend: Trockenätzverfahren, Ionensputtern, reaktives lonenätzen (RIE), plasmaunterstütztes Ätzen, Laserabtragung, Ionenfräsen, und Kombinationen davon.

5. Verfahren zur Bildung einer Mehrschichtstruktur durch Elektroplattierung auf einem Substrat (2), umfassend:
a) Anordnen einer elektrisch leitenden Keimschicht (1) auf mindestens einem Teil des Substrats (2) oder einer Substratschicht (2);
b) Anlegen einer Masterelektrode (4) an die Keimschicht (1), wobei die Masterelektrode (4) eine elektrisch leitende Elektrodenschicht (6), eine isolierende Musterschicht (5) und vorab abgeschiedenes Anodenmaterial (10), das auf der leitenden Elektrodenschicht (6) in den Hohlräumen der isolierenden Musterschicht (5) angeordnet ist, aufweist, zur Bildung mindestens einer elektrochemischen Zelle, umfassend einen Elektrolyten (3) in dem von dem Anodenmaterial (10), der isolierenden Musterschicht (5) und der Keimschicht (1) umschlossenen Gebiet; wobei das Anodenmaterial (10) in elektrischem Kontakt mit der leitenden Elektrodenschicht (6) steht;
c) Anlegen einer Spannung zwischen der leitenden Elektrodenschicht (6) und der Keimschicht (1), sodass die Keimschicht (1) eine Kathode bildet, die dazu dient, mindestens etwas von dem Anodenmaterial (10) in der mindestens einen Zelle auf die Keimschicht (1) zu übertragen, um plattierte Strukturen (11) zu bilden, die den Hohlräumen der isolierenden Musterschicht (5) an der Masterelektrode (4) entsprechen;
d) Trennen der Masterelektrode (4) von dem Substrat (2);
e) Entfernen der Keimschicht (1) in nicht plattierten Gebieten;
f) Anordnen eines dielektrischen Materials (9) durch Schleuderbeschichtung in den Gebieten zwischen den plattierten Strukturen (11), um eine Materialschicht (9) zu bilden, welche die plattierten Strukturen (11) bedeckt;
i) Anbringen von Ausnehmungen in der Materialschicht (9), um mindestens einen Teil der darunter befindlichen plattierten Struktur (11) freizulegen;
h) Wiederholen mindestens einiger der besagten Schritte, um eine Mehrschichtstruktur bereitzustellen.

6. Verfahren nach Anspruch 5, wobei der Schritt des Anbringens von Ausnehmungen in der Materialschicht (9) durch ein lithographisches Verfahren durchgeführt wird, das aus der Gruppe ausgewählt ist, umfassend: Photolithographie, Laserlithographie, Elektronenstrahllithographie, Nanoimprint-Verfahren und Kombinationen davon.

7. Verfahren nach Anspruch 6, wobei das lithographische Verfahren weiter das mit einem Muster Versehen einer Ätzmaske (15) und Ätzen der Materialschicht (9) mit Trockenätzverfahren, wie etwa Ionensputtern, reaktives lonenätzen, plasmaunterstütztes Ätzen, Laserabtragung, lonenfräsen oder Kombinationen umfasst.

8. Verfahren nach Anspruch 7, wobei die Ätzmaske (15) unter Verwendung eines Resists, wie etwa eines Photoresists, als Maske (15) trockengeätzt wird; wobei der Resist mit besagtem lithographischen Verfahren mit einem Muster versehen worden ist.

9. Verfahren nach Anspruch 5, wobei die Materialschicht (9) vor dem Anbringen von Ausnehmungen planarisiert wird.

10. Verfahren nach Anspruch 5, weiter das Anbringen einer Barriere-/Deckschicht **(14)** vor Schritt a) oder Schritt f) umfassend.

11. Verfahren nach einem der vorhergehenden Ansprüche, wobei der Planarisierungsschritt die Durchführung eines Polierschritts, bis die Materialoberfläche im Wesentlichen planar ist, und eines nachfolgenden Ätzschritts der Materialoberfläche, bis mindestens ein Teil der Strukturen **(11)** freigelegt ist, umfasst.

12. Verfahren nach einem der vorhergehenden Ansprüche, wobei vor der Durchführung des Planarisierungsschritts der Materialschicht **(9)** ein Planarisierungsmaterial auf dieser Materialschicht **(9)** angebracht wird.

13. Verfahren nach Anspruch **12,** wobei das Planarisierungsmaterial mit einem Verfahren angebracht wird, das aus der Gruppe ausgewählt ist, umfassend: Schleuderbeschichtung, Sprühbeschichtung, Pulverbeschichtung, Tauchbeschichtung, Walzenbeschichtung, Sputtern, PVD, CVD, PECVD, Elektroabscheidung und Kombinationen davon.

14. Verfahren nach einem der vorhergehenden Ansprüche, wobei ein Endpunkterfassungsverfahren angewendet wird, um zu bestimmen, wann der Planarisierungsschritt vollendet ist.

15. Verfahren nach einem der vorhergehenden Ansprüche, wobei der Schritt der Kontaktplanarisierung umfasst: Anbringen einer Platte über der Materialschicht **(9)** und Anlegen eines Drucks auf die Platte, um das Material **(9)** in der Materialschicht **(9)** zu egalisieren, während es in einem fließfähigen Zustand ist.

16. Verfahren nach Anspruch **15,** wobei der fließfähige Zustand durch Erhitzen der Materialschicht erhalten wird, woraufhin das Material nach dem Planarisieren abgekühlt wird.

17. Verfahren nach Anspruch **16,** wobei der Schritt des Anbringens der Platte vor dem Aushärten des Materials durchgeführt wird, woraufhin das Material nach dem Planarisieren ausgehärtet wird, etwa durch Anlegen von Infrarot- oder Ultraviolettstrahlung.

18. Verfahren nach Anspruch 1 oder 5, wobei die Keimschicht **(1)** aus Material hergestellt ist, das aus der Gruppe ausgewählt ist, umfassend: Ru, Os, Hf, Re, Cr, Au, Ag, Cu, Sn, Ti, TiN, TiW, Ni, NiB, NiP, NiCo, NiBW, NiM-P, AI, Pd, Pt, W, Ta, TaN, Rh, Wo, Co, CoReP, CoP, CoWP, CoWB, CoWBP, Legierungen dieser Materialien, Si, leitende Polymere, wie etwa Polyanilin; Lötmaterialien, wie etwa SnPb, SnAg, SnAgCu, SnCu, Legierungen, wie etwa Monel und Permalloy; und Legierungen davon und Kombinationen davon.

19. Verfahren nach Anspruch 18, wobei die Keimschicht **(1)** durch ein Verfahren angebracht wird, das aus der Gruppe ausgewählt ist, umfassend: chemische Dampfabscheidung (CVD), metallorganischchemische Dampfabscheidung (MOCVD), physikalische Dampfabscheidung (PVD), Atomlagenabscheidung (ALD), Sputtern, stromloses Plattieren, Elektroplattierung, Elektropfropfung, Tauchabscheidung, und Kombinationen davon.

20. Verfahren nach Anspruch 10, wobei das Barriere-/Deckmaterial mindestens eine Materialschicht umfasst, die Korrosion, Diffusion oder Elektromigration von Schichten verhindert, die eine Schnittstelle mit dem Barriere-/Deckmaterial aufweisen.

21. Verfahren nach Anspruch 10, wobei das Barriere-/Deckmaterial durch ein Verfahren angebracht wird, das aus der Gruppe ausgewählt ist, umfassend: Elektroabscheidung, MOCVD, CVD, PVD, ALD, Sputtern, stromlose Abscheidung, Tauchabscheidung, Elektropfropfung und Kombinationen davon.

22. Verfahren nach Anspruch 21, wobei das Barriere-/Deckmaterial mit einem maskenlosen selektiven Abscheidungsverfahren angebracht wird, wie etwa stromloser Abscheidung, wobei die Abscheidung nur in Oberflächen erhalten wird, die aktiv sind für den Abscheidungsprozess, wie etwa auf der Strukturschicht **(11),** und nicht auf der besagten angeordneten Materialschicht **(9).**

23. Verfahren nach Anspruch 10, wobei das Barriere-/Deckmaterial als Keimschicht **(1)** in Schritt a) verwendet wird.

24. Verfahren nach Anspruch 10, weiter das Anbringen einer Haftschicht vor dem Anbringen der Keimschicht **(1)** und/oder vor dem Anbringen des Barriere-/Deckmaterials umfassend; wobei besagte Haftschicht die Haftung der Keimschicht **(1)** oder der Barriere-/Deckschicht **(14)** an der angeordneten Materialschicht **(9)** oder den Strukturen **(11)** erhöht.

25. Verfahren nach einem der vorhergehenden Ansprüche, wobei die Bildung mindestens einer elektrochemischen Zelle ein Verfahren zur Ausrichtung der isolierenden Musterschicht **(5)** zu einer gemusterten Schicht auf dem Substrat **(2)** umfasst, wobei das Ausrichtverfahren die Verwendung von Ausrichtmarkierungen auf der Vorderseite und/oder Rückseite der Masterelektrode **(4),** die zu entsprechenden Ausrichtmarken auf dem Substrat **(2)** ausgerichtet sind, umfasst.

26. Verfahren nach einem der vorhergehenden Ansprüche, wobei die gebildete elektrochemische Zelle eine Lösung von Kationen, wie etwa Kupfer- oder Nickelionen, und Anionen, wie etwa Sulfationen, zum elektrochemischen Ätzen und/oder Plattieren umfasst.

27. Verfahren nach Anspruch 26, wobei der Elektrolyt **(3)** Suppressoren, Nivelliermittel und/oder Beschleunigungsmittel umfasst, beispielsweise PEG (Polyethylenglykol) zusammen mit Chloridionen und/oder mit SPS (Bis-(3-sulfopropyl)-disulfid), MPSA und/oder Natriumlaurylsulfat.

28. Verfahren nach einem der vorhergehenden Ansprüche, wobei das Anodenmaterial **(10)** auf der leitenden Elektrodenschicht **(6)** in den Hohlräumen der isolierenden Musterschicht **(5)** angeordnet wird unter Verwendung eines Verfahrens, das aus der Gruppe ausgewählt ist, umfassend: Elektroplattierung, stromloses Plattieren, Tauchplattierung, CVD, MOCVD, Pulverbeschichtung, chemische Pfropfung, Elektropfropfung und Kombinationen davon.

29. Verfahren nach einem der vorhergehenden Ansprüche, wobei der Trennschritt d) durchgeführt wird, indem das Substrat **(2)** in einer festen Position gehalten wird und die Masterelektrode **(4)** in einer Richtung senkrecht zur Oberfläche des Substrats **(2)** bewegt wird; oder indem die Masterelektrode **(4)** in einer festen Position gehalten wird und das Substrat **(2)** in einer Richtung senkrecht zur Oberfläche der Masterelektrode **(4)** bewegt wird; oder indem die Trennung auf weniger parallele Weise durchgeführt wird, um die Trennung zu erleichtern; oder durch eine Kombination davon.

30. Verfahren nach einem der vorhergehenden Ansprüche, wobei besagter Schritt e) des Entfernens der Keimschicht **(1)** durch Nassätzen, Trockenätzen, elektrochemisches Ätzen oder durch Kombinationen davon durchgeführt wird.

31. Verfahren nach Anspruch 30, weiter das Anbringen einer schützenden Beschichtung umfassend, die die gesamte oder im Wesentlichen die gesamte Keimschicht **(1),** Barriere-/Deckschicht **(14)** und/oder Strukturschicht **(11)** bedeckt; Behandeln der schützenden Beschichtung mit einer anisotropen Ätzung, wodurch die Oberseite der Keimschicht **(1),** Barriere-/Deckschicht **(14)** und/oder Strukturschicht **(11)** zwischen den Strukturen **(11)** freigelegt wird, während eine schützende Schicht auf den Seitenwänden der Strukturen **(11)** belassen wird; Entfernen der Keimschicht **(1)** und/oder Barriereschicht **(14)** zwischen den Strukturen **(11).**

32. Verfahren nach einem der vorhergehenden Ansprüche, weiter umfassend: Anordnen einer Ätzstoppschicht oben auf den Strukturen **(11)** vor dem Schritt f) des Anordnens des Materials **(9).**

33. Verfahren nach einem der vorhergehenden Ansprüche, wobei die Materialschicht **(9)** ein poröses Material **(9)** mit niedriger Dielektrizitätskonstante ist und vor dem darauf Anbringen weiterer Materialschichten ein Porenversiegelungsvorgang durchgeführt wird.

## Revendications

1. Procédé de formation d'une structure multicouche par dépôt électrolytique sur un substrat **(2),** comprenant les étapes consistant à :
**a)** disposer une couche de germination électroconductrice **(1)** sur au moins une partie du substrat **(2)** ou sur une couche de substrat **(2)** ;
**b)** appliquer une électrode maître **(4)** sur ladite couche de germination **(1),** ladite électrode maître **(4)** possédant une couche électroconductrice **(6)** faisant office d'électrode, une couche **(5)** sous la forme d'un motif d'isolation et une matière **(10)** déposée au préalable, faisant office d'anode, disposée par-dessus ladite couche conductrice **(6)** faisant office d'électrode dans les cavités de ladite couche **(5)** sous la forme d'un motif d'isolation pour former au moins une cellule électrochimique comprenant un électrolyte **(3)** dans la zone renfermée par ladite matière **(10)** faisant office d'anode, par ladite couche **(5)** sous la forme d'un motif d'isolation et par ladite couche de germination **(1) ;** dans lequel ladite matière **(10)** faisant office d'anode est mise en contact électrique avec ladite couche conductrice **(6)** faisant office d'électrode ;
**c)** appliquer une tension entre ladite couche conductrice **(6)** faisant office d'électrode et ladite couche de germination **(1)** d'une manière telle que ladite couche de germination **(1)** forme une cathode pour transférer au moins une certaine quantité de ladite matière **(10)** faisant office d'anode dans ladite au moins une cellule à ladite couche de germination **(1)** pour former des structures plaquées **(11)** de manière correspondante aux cavités de la couche **(5)** sous la forme d'un motif d'isolation sur l'électrode maître **(4) ;**
**d)** séparer ladite électrode maître **(4)** dudit substrat **(2)** ;
**e)** retirer ladite couche de germination **(1)** dans les zones non plaquées;
**f)** disposer un matériau diélectrique **(9)** via une technique de dépôt par rotation dans les zones situées entre les structures plaquées **(11)** pour former une couche de matière **(9)** qui recouvre au moins en partie lesdites structures plaquées **(11)** ;
**g)** soumettre la couche de matière **(9)** à une planarisation jusqu'à obtenir une mise à nu d'au moins une partie des structures **(11) ;**
h) répéter au moins un certain nombre desdites étapes pour obtenir une structure multicouche.

2. Procédé selon la revendication **1,** dans lequel l'étape de planarisation comprend en outre le fait d'éliminer une quantité supplémentaire de matière **(9)** via un procédé d'élimination possédant un taux d'élimination essentiellement uniforme sur toute la surface jusqu'à obtenir une mise à nu d'au moins une partie des structures **(11).**

3. Procédé selon la revendication **1,** comprenant en outre le fait de, entre les étapes d) et e) :
appliquer une électrode maître supplémentaire **(4)** pour la formation de cellules électrochimiques avec les structures **(11)** préalablement formées ; et
appliquer une tension pour former une couche supplémentaire de structures plaquées **(11)** par-dessus la couche de structures **(11)** préalablement formée.

4. Procédé selon les revendications 1 à 3, dans lequel ladite étape de planarisation est mise en oeuvre via au moins une étape de polissage choisie parmi le groupe comprenant: un polissage mécanique, un polissage chimique, un polissage chimico-mécanique **(CMP),** une planarisation par contact **(CP),** une planarisation avec une lame de racloir, ainsi que leurs combinaisons, et/ou une étape de gravure choisie parmi le groupe comprenant : des procédés de gravure par voie sèche, une pulvérisation ionique, une gravure par ions réactifs **(RIE),** une gravure assistée par plasma, une ablation au laser, un usinage ionique, ainsi que leurs combinaisons.

5. Procédé de formation d'une structure multicouche par dépôt électrolytique sur un substrat **(2),** comprenant le fait de :
a) disposer une couche de germination électroconductrice **(1)** sur au moins une partie du substrat **(2)** ou sur une couche de substrat (2) ;
**b)** appliquer une électrode maître **(4)** sur ladite couche de germination **(1),** ladite électrode maître **(4)** possédant une couche électroconductrice **(6)** faisant office d'électrode, une couche **(5)** sous la forme d'un motif d'isolation et une matière **(10)** déposée au préalable, faisant office d'anode, disposée par-dessus ladite couche conductrice **(6)** faisant office d'électrode dans les cavités de ladite couche **(5)** sous la forme d'un motif d'isolation pour former au moins une cellule électrochimique comprenant un électrolyte **(3)** dans la zone renfermée par ladite matière **(10)** faisant office d'anode, par ladite couche **(5)** sous la forme d'un motif d'isolation et par ladite couche de germination **(1)** ; dans lequel ladite matière **(10)** faisant office d'anode est mise en contact électrique avec ladite couche conductrice **(6)** faisant office d'électrode ;
**c)** appliquer une tension entre ladite couche conductrice **(6)** faisant office d'électrode et ladite couche de germination **(1)** d'une manière telle que ladite couche de germination **(1)** forme une cathode pour transférer au moins une certaine quantité de ladite matière **(10)** faisant office d'anode dans ladite au moins une cellule à ladite couche de germination **(1)** pour former des structures plaquées **(11)** de manière correspondante aux cavités de la couche **(5)** sous la forme d'un motif d'isolation sur l'électrode maître **(4)** ;
**d)** séparer ladite électrode maître **(4)** dudit substrat **(2)** ;
**e)** retirer ladite couche de germination **(1)** dans les zones non plaquées ;
**f)** disposer un matériau diélectrique **(9)** via une technique de dépôt par rotation dans les zones situées entre les structures plaquées **(11)** pour former une couche de matière **(9)** qui recouvre lesdites structures plaquées **(11)** ;
**i)** procurer des évidements dans ladite couche de matière **(9)** pour la mise à nu d'au moins une partie des structures plaquées **(11)** situées en dessous ;
**h)** répéter au moins un certain nombre desdites étapes pour obtenir une structure multicouche.

6. Procédé selon la revendication 5, dans lequel ladite étape consistant procurer des évidements dans ladite matière **(9)** est mise en oeuvre via un procédé lithographique choisi parmi le groupe comprenant : une photolithographie, une lithographie au laser, une lithographie par faisceau électronique, une nanoimpression, ainsi que leurs combinaisons.

7. Procédé selon la revendication 6, dans lequel ledit procédé lithographique comprend en outre la modélisation d'un masque de gravure **(15)** et la gravure de ladite couche de matière **(9)** avec des procédés de gravure par voie sèche, comme par exemple une pulvérisation ionique, une gravure par ions réactifs, une gravure assistée par plasma, une ablation laser, un usinage ionique ou leurs combinaisons.

8. Procédé selon la revendication 7, dans lequel ledit masque de gravure **(5)** est soumis à une gravure par voie sèche en utilisant une réserve, telle qu'une photoréserve, pour faire office de masque **(15)** ; tandis que ladite réserve a été modélisée avec ledit procédé lithographique.

9. Procédé selon la revendication 5, dans lequel ladite couche de matière **(9)** fait l'objet d'une planarisation avant le fait de procurer des évidements.

10. Procédé selon la revendication 5, comprenant en outre le fait d'appliquer une couche faisant office de barrière/recouvrement **(14)** avant l'étape a) ou avant l'étape f).

11. Procédé selon l'une quelconque des revendications précédentes, dans lequel ladite étape de planarisation comprend la mise en oeuvre d'une étape de polissage jusqu'à ce que ladite surface de matière soit essentiellement plane et une étape de gravure ultérieure de ladite surface de matière jusqu'à ce que l'on obtienne une mise à nu d'au moins une partie desdites structures **(11).**

12. Procédé selon l'une quelconque des revendications précédentes, dans lequel on applique une matière de planarisation sur ladite couche de matière **(9)** avant la mise en oeuvre de ladite étape de planarisation de ladite couche de matière **(9).**

13. Procédé selon la revendication 12, dans lequel ladite matière de planarisation est appliquée avec un procédé choisi parmi le groupe comprenant : une technique de dépôt par rotation, une technique de dépôt par pulvérisation, une enduction avec de la poudre, un revêtement par immersion, une enduction au rouleau, une pulvérisation cathodique, un dépôt physique en phase vapeur, un dépôt chimique en phase vapeur, un dépôt chimique en phase vapeur activé par plasma, un dépôt électrolytique, ainsi que leurs combinaisons.

14. Procédé selon l'une quelconque des revendications précédentes, dans lequel un procédé de détection du point final est utilisé de façon à déterminer le moment correspondant à l'achèvement de ladite étape de planarisation.

15. Procédé selon l'une quelconque des revendications précédentes, dans lequel l'étape de planarisation par contact comprend le fait de : appliquer une plaque par-dessus ladite couche de matière **(9)** et exercer une pression sur ladite plaque pour l'égalisation de la matière **(9)** dans ladite couche de matière **(9)** tandis que cette dernière se trouve dans un état apte à s'écouler.

16. Procédé selon la revendication **15,** dans lequel ledit état apte à s'écouler est obtenu par chauffage de ladite couche de matière ; après quoi, la matière est refroidie suite à la planarisation.

17. Procédé selon la revendication **16,** dans lequel ladite étape d'application de la plaque est mise en oeuvre avant le durcissement de ladite matière ; après quoi la matière est durcie suite à la planarisation par exemple via l'application d'un rayonnement infrarouge ou ultraviolet.

18. Procédé selon la revendication 1 ou 5, dans lequel la couche de germination **(1)** est réalisée à partir d'une matière choisie parmi le groupe comprenant : Ru, Os, Hf, Re, Cr, Au, Ag, Cu, Sn, Ti, TiN, TiW, Ni, NiB, NiP, NiCo, NiBW, NiM-P, Al, Pd, Pt, W, Ta, TaN, Rh, Wo, Co, CoReP, CoP, CoWP, CoWBn, CoWBP, des alliages de ses matières, Si, des polymères conducteurs tels que la polyaniline ; des matières de brasage, telles que SnPb, SnAg, SnAgCu, SnCu, des alliages tels que le monel et le permalloy ; ainsi que leurs alliages et leurs combinaisons.

19. Procédé selon la revendication 18, dans lequel la couche de germination **(1)** est appliquée via un procédé choisi parmi le groupe comprenant : un dépôt chimique en phase vapeur (CVD), un dépôt en phase vapeur à partir de composés organométalliques (MOCVD), un dépôt physique en phase vapeur (PVD), un dépôt en couches atomiques (ALD), une pulvérisation cathodique, un dépôt autocatalytique, un électrogreffage, un dépôt par immersion, ainsi que leurs combinaisons.

20. Procédé selon la revendication 10, dans lequel ladite matière faisant office de barrière/de revêtement comprend au moins une couche de matière qui empêche la corrosion, la diffusion ou l'électromigration de couches placées en interface avec ladite matière faisant office de barrière/de revêtement.

21. Procédé selon la revendication 10, dans lequel ladite matière faisant office de barrière/de revêtement est appliquée via un procédé choisi parmi le groupe comprenant : un dépôt électrolytique, un dépôt chimique en phase vapeur à partir de composés organométalliques, un dépôt chimique en phase vapeur, un dépôt physique en phase vapeur, un dépôt en couches atomiques, une pulvérisation cathodique, un dépôt autocatalytique, un dépôt par immersion, un électrogreffage ainsi que leurs combinaisons.

22. Procédé selon la revendication 21, dans lequel ladite matière faisant office de barrière/de revêtement est appliquée avec un procédé de dépôt sélectif exempt de masque, tel qu'un dépôt autocatalytique, dans lequel on obtient un dépôt uniquement dans des surfaces actives vis-à-vis dudit procédé de dépôt, par exemple sur ladite couche de structures **(11)** et non sur ladite couche de matière arrangée **(9).**

23. Procédé selon la revendication 10, dans lequel ladite matière faisant office de barrière/de revêtement est utilisée à titre de couche de germination **(1)** dans ladite étape a).

24. Procédé selon la revendication 10, comprenant en outre l'application d'une couche d'adhésion avant l'application de ladite couche de germination **(1)** et/ou avant l'application de ladite matière faisant office de barrière/de revêtement ; dans lequel ladite couche d'adhésion augmente l'adhérence de ladite couche de germination **(1)** ou de ladite couche faisant office de barrière/de revêtement **(14)** à ladite couche de matière arrangée **(9)** ou auxdites structures **(11).**

25. Procédé selon l'une quelconque des revendications précédentes, dans lequel ladite formation de ladite au moins une cellule électrochimique comprend un procédé destiné à aligner ladite couche sous la forme d'un motif d'isolation **(5)** par rapport à une couche modélisée sur ledit substrat **(2)** ; dans lequel ledit procédé d'alignement comprend le fait d'utiliser des repères d'alignement sur le côté avant et/ou sur le côté arrière de ladite électrode maître **(4)** qui sont mises en alignement par rapport à des repères de mise en alignement correspondants sur ledit substrat **(2).**

26. Procédé selon l'une quelconque des revendications précédentes, dans lequel ladite cellule électrochimique obtenue comprend une solution de cations, tels que des ions cuivre ou des ions nickel, et d'anions tels que des ions sulfates, pour la gravure et/ou le placage électrochimique.

27. Procédé selon la revendication 26, dans lequel ledit électrolyte (3) comprend des agents de suppression, des agents de nivellement et/ou des agents d'accélération, par exemple du PEG (polyéthylèneglycol) conjointement avec des ions chlorure et/ou avec du SPS (bis-(3-sulfopropyle)-disulfure), du MPSA et/ou du laurylsulfate de sodium.

28. Procédé selon l'une quelconque des revendications précédentes, dans lequel ladite matière anodique **(10)** est arrangée sur ladite couche conductrice **(6)** faisant office d'électrode dans les cavités de ladite couche **(5)** sous la forme d'un motif d'isolation en utilisant un procédé choisi parmi le groupe comprenant : un dépôt électrolytique, un placage autocatalytique, un placage par immersion, un dépôt chimique en phase vapeur, un dépôt chimique en phase vapeur à partir de composés organométalliques, une enduction avec de la poudre, un greffage chimique, un électrogreffage, ainsi que leurs combinaisons.

29. Procédé selon l'une quelconque des revendications précédentes, dans lequel ladite étape de séparation d) est mise en oeuvre en maintenant ledit substrat **(2)** dans une position fixe et en déplaçant ladite électrode maître **(4)** dans une direction perpendiculaire à la celle de la surface du substrat **(2) ;** ou en maintenant ladite électrode maître **(4)** dans une position fixe et en déplaçant ledit substrat **(2)** dans une direction perpendiculaire à celle de la surface de l'électrode maître **(4) ;** ou en procédant à la séparation d'une manière moins parallèle de façon à faciliter la séparation ; ou via une de leurs combinaisons.

30. Procédé selon l'une quelconque des revendications précédentes, dans lequel ladite étape e) d'élimination de ladite couche de germination **(1)** est mise en oeuvre via une gravure par voie humide, une gravure par voie sèche, une gravure électrochimique ou via une de leurs combinaisons.

31. Procédé selon la revendication 30, comprenant en outre le fait de : appliquer un revêtement de protection qui recouvre la totalité ou essentiellement la totalité de ladite couche de germination **(1),** de ladite couche faisant office de barrière/de revêtement **(14)** et/ou de la couche de structures **(11)** ; traiter ledit revêtement de protection avec un agent de gravure anisotrope pour ainsi mettre à nu le sommet de ladite couche de germination **(1),** de la couche faisant office de barrière/de revêtement **(14)** et/ou de la couche de structures **(11)** entre les structures **(11),** tout en laissant subsister une couche de protection sur les parois latérales desdites structures **(11)** ; retirer ladite couche de germination **(1)** et/ou la couche faisant office de barrière **(14)** entre lesdites structures **(11).**

32. Procédé selon l'une quelconque des revendications précédentes, comprenant en outre le fait de : arranger une couche d'arrêt de gravure par-dessus les structures **(11)** avant l'étape f) dans laquelle la matière **(9)** est arrangée.

33. Procédé selon l'une quelconque des revendications précédentes, dans lequel ladite couche de matière **(9)** représente un matériau diélectrique poreux à faible constante diélectrique, et une opération d'étanchéisation des pores est mise en oeuvre avant l'application de couches supplémentaires de matière sur la première citée.
